(19) Europäisches Patentamt
European Patent Office
Office européen des brevets

(11) **EP 1 470 724 B1**

(12) **EUROPEAN PATENT SPECIFICATION**

(45) Date of publication and mention
of the grant of the patent:
**19.11.2014 Bulletin 2014/47**

(51) Int Cl.:
*H03M 7/40* (2006.01)       *H03M 7/42* (2006.01)
*H04N 19/107* (2014.01)     *H04N 19/61* (2014.01)
*H04N 19/13* (2014.01)      *H04N 19/91* (2014.01)
*H04N 19/137* (2014.01)

(21) Application number: **03700324.1**

(22) Date of filing: **22.01.2003**

(86) International application number:
**PCT/FI2003/000056**

(87) International publication number:
**WO 2003/063501 (31.07.2003 Gazette 2003/31)**

(54) **CODING TRANSFORM COEFFICIENTS IN IMAGE/VIDEO ENCODERS AND/OR DECODERS**

CODIERUNGSTRANSFORMATIONSKOEFFIZIENTEN IN BILD-/VIDEOCODIERERN UND/ODER -DECODIERERN

CODAGE DE COEFFICIENTS DE TRANSFORMATION DANS DES CODEURS ET/OU DECODEURS IMAGE/VIDEO

(84) Designated Contracting States:
**AT BE BG CH CY CZ DE DK EE ES FI FR GB GR HU IE IT LI LU MC NL PT SE SI SK TR**

(30) Priority: **22.01.2002 US 54610**
**02.04.2002 US 369500 P**

(43) Date of publication of application:
**27.10.2004 Bulletin 2004/44**

(73) Proprietor: **Nokia Corporation**
**02610 Espoo (FI)**

(72) Inventors:
• **KARCZEWICZ, Marta**
**Irving, TX 75038 (US)**
• **KURCEREN, Ragip**
**Carollton, TX 75007 (US)**

(74) Representative: **Tampereen Patenttitoimisto Oy**
**Hermiankatu 1 B**
**33720 Tampere (FI)**

(56) References cited:
**EP-A2- 0 279 799     US-A- 5 400 075**
**US-A- 5 640 420**

• 'ITU-Telecommunications Standardization Sector, Study Group 16 Questions 6, Video Coding Experts Group, 15th Meeting', PATTAYA, THAILAND article MARPE D. ET AL: 'Improved CABAC', XP002257293 4-6 dec. 2001, chapter 2.2
• 'ITU-Telecommunications Standardization Sector, Study Group 16, Video Coding Experts Group (Question 15). 11th Meeting', PORTLAND, OREGON, USA article BJONTEGAARD G.: 'Use of adaptive switching between two VLCs for intra luma coefficients', XP002257295 22-25 aug. 2000, chapters 2 and 3
• 'Joint Video Team (JVT) of ISO/IEC MPEG & ITU-T VCEG (SIO/IEC JTC1/SC29/WG11 and ITU-T SG16 Q.6) 2nd Meeting', GENEVA, CH article BJONTEGAARD G.: 'Improved low complexity entropy coding for transform coefficients', XP002257294 jan.29-feb.1 2002, chapter 2

**Description**

Field of the Invention

The invention relates to a method, a system and a device for the coding of digital video. More specifically, the invention concerns the coding of quantised transform coefficients produced as a result of block-based transform coding in a video / image encoder / decoder using Variable Length Coding (VLC).

Background of the invention

Digital video sequences, like ordinary motion pictures recorded on film, comprise a sequence of still images, the illusion of motion being created by displaying the images one after the other at a relatively fast rate, typically 15 to 30 frames per second. Because of the relatively fast display rate, images in consecutive frames tend to be quite similar and thus contain a considerable amount of redundant information. For example, a typical scene may comprise some stationary elements, such as background scenery, and some moving areas, which may take many different forms, for example the face of a newsreader, moving traffic and so on. Alternatively, the camera recording the scene may itself be moving, in which case all elements of the image have the same kind of motion. In many cases, this means that the overall change between one video frame and the next is rather small.

Each frame of an uncompressed digital video sequence comprises an array of image pixels. For example, in a commonly used digital video format, known as the Quarter Common Interchange Format (QCIF), a frame comprises an array of 176 x 144 pixels, in which case each frame has 25,344 pixels. In turn, each pixel is represented by a certain number of bits which carry information about the luminance and/or colour content of the region of the image corresponding to the pixel. Commonly, a so-called YUV colour model is used to represent the luminance and chrominance content of the image. The luminance, or Y, component represents the intensity (brightness) of the image, while the colour content of the image is represented by two chrominance or colour difference components, labelled U and V.

Colour models based on a luminance/chrominance representation of image content provide certain advantages compared with colour models that are based on a representation involving primary colours (that is Red, Green and Blue, RGB). The human visual system is more sensitive to intensity variations than it is to colour variations and YUV colour models exploit this property by using a lower spatial resolution for the chrominance components (U, V) than for the luminance component (Y). In this way, the amount of information needed to code the colour information in an image can be reduced with an acceptable reduction in image quality.

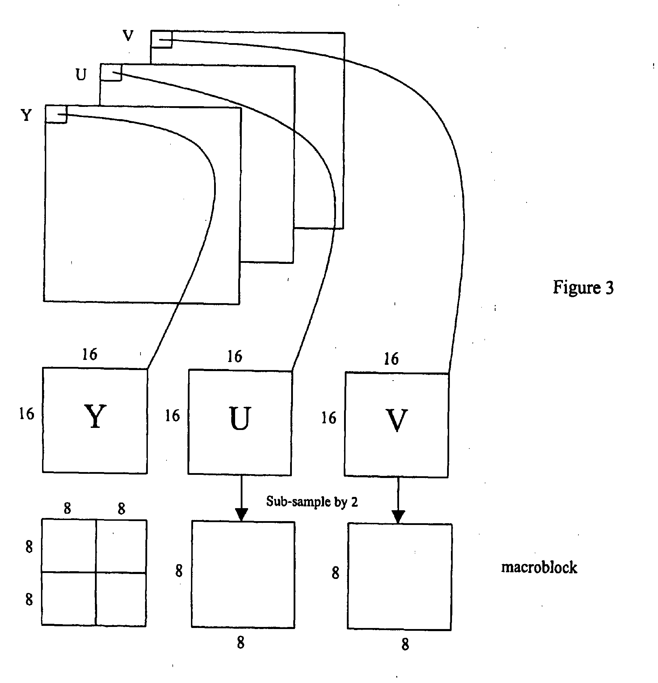

The lower spatial resolution of the chrominance components is usually attained by sub-sampling. Typically, each frame of a video sequence is divided into so-called 'macroblocks', which comprise luminance (Y) information and associated chrominance (U, V) information which is spatially sub-sampled. Figure 3 illustrates one way in which macroblocks can be formed. Figure 3a shows a frame of a video sequence represented using a YUV colour model, each component having the same spatial resolution. Macroblocks are formed by representing a region of 16x16 image pixels in the original image (Figure 3b) as four blocks of luminance information, each luminance block comprising an 8x8 array of luminance (Y) values and two spatially corresponding chrominance components (U and V) which are sub-sampled by a factor of two in the x and y directions to yield corresponding arrays of 8x8 chrominance (U, V) values (see Figure 3c). According to certain video coding recommendations, such as International Telecommunications Union (ITU-T) recommendation H.26L, the fundamental block size used within the macroblocks can be other than 8x8, for example 4x8 or 4x4. (See G. Bjontegaard, "H.26L Test Model Long Term Number 8 (TML-8) draft 0", VCEG-N10, June 2001, section 2.3).

A QCIF image comprises 11x9 macroblocks. If the luminance blocks and chrominance blocks are represented with 8 bit resolution (that is by numbers in the range 0 to 255), the total number of bits required per macroblock is (16x16x8)+2x(8x8x8) = 3072 bits. The number of bits needed to represent a video frame in QCIF format is thus 99x3072 = 304,128 bits. This means that the amount of data required to transmit/record/display an uncompressed video sequence in QCIF format, represented using a YUV colour model, at a rate of 30 frames per second, is more than 9 Mbps (million bits per second). This is an extremely high data rate and is impractical for use in video recording, transmission and display applications because of the very large storage capacity, transmission channel capacity and hardware performance required.

If video data is to be transmitted in real-time over a fixed line network such as an ISDN (Integrated Services Digital Network) or a conventional PSTN (Public Switched Telephone Network), the available data transmission bandwidth is typically of the order of 64kbits/s. In mobile videotelephony, where transmission takes place at least in part over a radio communications link, the available bandwidth can be as low as 20kbits/s. This means that a significant reduction in the amount of information used to represent video data must be achieved in order to enable transmission of digital video sequences over low bandwidth communication networks. For this reason, video compression techniques have been developed which reduce the amount of information transmitted while retaining an acceptable image quality.

Video compression methods are based on reducing the redundant and perceptually irrelevant parts of video sequences. The redundancy in video sequences can be categorised into spatial, temporal and spectral redundancy. 'Spatial redundancy' is the term used to describe the correlation (similarity) between neighbouring pixels within a frame. The term 'temporal redundancy' expresses the fact that objects appearing in one frame of a sequence are likely to appear in subsequent frames, while 'spectral redundancy' refers to the correlation between different colour components of the same image.

Sufficiently efficient compression cannot usually be achieved by simply reducing the various forms of redundancy in a given sequence of images. Thus, most current video encoders also reduce the quality of those parts of the video sequence which are subjectively the least important. In addition, the redundancy of the compressed video bit-stream itself is reduced by means of efficient loss-less encoding. Generally, this is achieved using a technique known as entropy coding.

There is often a significant amount of spatial redundancy between the pixels that make up each frame of a digital video sequence. In other words, the value of any pixel within a frame of the sequence is substantially the same as the value of other pixels in its immediate vicinity. Typically, video coding systems reduce spatial redundancy using a technique known as 'block-based transform coding', in which a mathematical transformation is applied to the pixels of an image, on a macroblock-by-macroblock basis. Transform coding translates the image data from a representation comprising pixel values to a form comprising a set of coefficient values, each of which is a weighting factor (multiplier) for a basis function of the transform in question. By using certain mathematical transformations, such as the two-dimensional Discrete Cosine Transform (DCT), the spatial redundancy within a frame of a digital video sequence can be significantly reduced, thereby producing a more compact representation of the image data.

Frames of a video sequence which are compressed using block-based transform coding, without reference to any other frame within the sequence, are referred to as INTRA-coded or I-frames. Additionally, and where possible, blocks of INTRA-coded frames are predicted from previously coded blocks within the same frame. This technique, known as INTRA-prediction, has the effect of further reducing the amount of data required to represent an INTRA-coded frame.

Generally, video coding systems not only reduce the spatial redundancy within individual frames of a video sequence, but also make use of a technique known as 'motion-compensated prediction', to reduce the temporal redundancy in the sequence. Using motion-compensated prediction, the image content of some (often many) frames in a digital video sequence is 'predicted' from one or more other frames in the sequence, known as 'reference' or 'anchor' frames. Prediction of image content is achieved by tracking the motion of objects or regions of an image between a frame to be coded (compressed) and the reference frame(s) using 'motion vectors'. In general, the reference frame(s) may precede the frame to be coded or may follow it in the video sequence. As in the case of INTRA-coding, motion compensated prediction of a video frame is typically performed macroblock-by-macroblock.

Frames of a video sequence which are compressed using motion-compensated prediction are generally referred to as INTER-coded or P-frames. Motion-compensated prediction alone rarely provides a sufficiently precise representation of the image content of a video frame and therefore it is typically necessary to provide a so-called 'prediction error' (PE) frame with each INTER-coded frame. The prediction error frame represents the difference between a decoded version of the INTER-coded frame and the image content of the frame to be coded. More specifically, the prediction error frame comprises values that represent the difference between pixel values in the frame to be coded and corresponding reconstructed pixel values formed on the basis of a predicted version of the frame in question. Consequently, the prediction error frame has characteristics similar to a still image and block-based transform coding can be applied in order to reduce its spatial redundancy and hence the amount of data (number of bits) required to represent it.

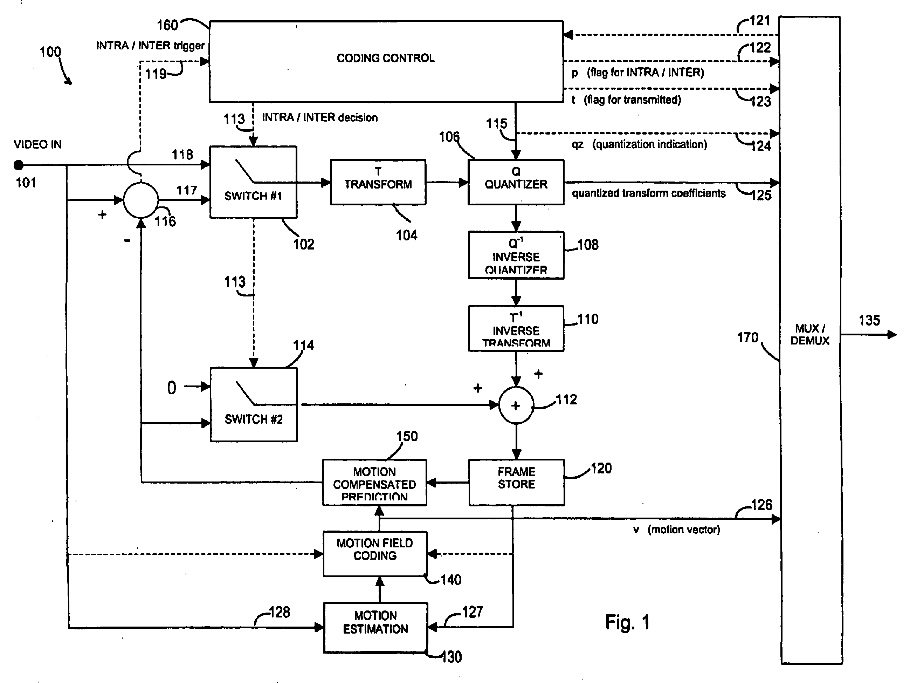

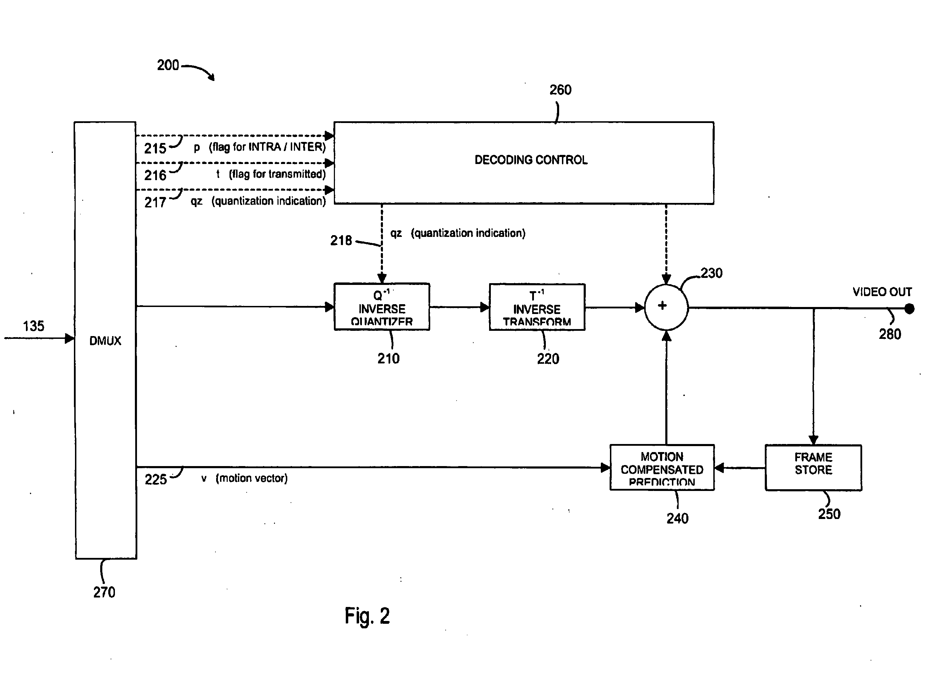

In order to illustrate the operation of a video coding system in greater detail, reference will now be made to Figures 1 and 2. Figure 1 is a schematic diagram of a generic video encoder that employs a combination of INTRA- and INTER-coding to produce a compressed (encoded) video bit-stream. A corresponding decoder is illustrated in Figure 2 and will be described later in the text.

The video encoder 100 comprises an input 101 for receiving a digital video signal from a camera or other video source (not shown). It also comprises a transformation unit 104 which is arranged to perform a block-based discrete cosine transform (DCT), a quantiser 106, an inverse quantiser 108, an inverse transformation unit 110, arranged to perform an inverse block-based discrete cosine transform (IDCT), combiners 112 and 116, and a frame store 120. The encoder further comprises a motion estimator 130, a motion field coder 140 and a motion compensated predictor 150. Switches 102 and 114 are operated co-operatively by control manager 160 to switch the encoder between an INTRA-mode of video encoding and an INTER-mode of video encoding. The encoder 100 also comprises a video multiplex coder 170 which forms a single bit-stream from the various types of information produced by the encoder 100 for further transmission to a remote receiving terminal or, for example, for storage on a mass storage medium, such as a computer hard drive (not shown).

Encoder 100 operates as follows. Each frame of uncompressed video provided from the video source to input 101 is received and processed macroblock by macroblock, preferably in raster-scan order. When the encoding of a new video sequence starts, the first frame to be encoded is encoded as an INTRA-coded frame. Subsequently, the encoder is programmed to code each frame in INTER-coded format, unless one of the following conditions is met: 1) it is judged that the current macroblock of the frame being coded is so dissimilar from the pixel values in the reference frame used in its prediction that excessive prediction error information is produced, in which case the current macroblock is coded in INTRA-coded format; 2) a predefined INTRA frame repetition interval has expired; or 3) feedback is received from a receiving terminal indicating a request for a frame to be provided in INTRA-coded format.

The occurrence of condition 1) is detected by monitoring the output of the combiner 116. The combine 116 forms a difference between the current macroblock of the frame being coded and its prediction, produced in the motion compensated prediction block 150. If a measure of this difference (for example a sum of absolute differences of pixel values) exceeds a predetermined threshold, the combiner 116 informs the control manager 160 via a control line 119 and the control manager 160 operates the switches 102 and 114 via control line 113 so as to switch the encoder 100 into INTRA-coding mode. In this way, a frame which is otherwise encoded in INTER-coded format may comprise INTRA-coded macroblocks. Occurrence of condition 2) is monitored by means of a timer or frame counter implemented in the control manager 160, in such a way that if the timer expires, or the frame counter reaches a predetermined number of frames, the control manager 160 operates the switches 102 and 114 via control line 113 to switch the encoder into INTRA-coding mode. Condition 3) is triggered if the control manager 160 receives a feedback signal from, for example, a receiving terminal, via control line 121 indicating that an INTRA frame refresh is required by the receiving terminal. Such a condition may arise, for example, if a previously transmitted frame is badly corrupted by interference during its transmission, rendering it impossible to decode at the receiver. In this situation, the receiving decoder issues a request for the next frame to be encoded in INTRA-coded format, thus re-initialising the coding sequence.

Operation of the encoder 100 in INTRA-coding mode will now be described. In INTRA-coding mode, the control manager 160 operates the switch 102 to accept video input from input line 118. The video signal input is received macroblock by macroblock from input 101 via the input line 118. As they are received, the blocks of luminance and chrominance values which make up the macroblock are passed to the DCT transformation block 104, which performs a 2-dimensional discrete cosine transform on each block of values, producing a 2-dimensional array of DCT coefficients for each block. DCT transformation block 104 produces an array of coefficient values for each block, the number of coefficient values depending on the nature of the blocks which make up the macroblock. For example, if the fundamental block size used in the macroblock is 4x4, DCT transformation block 104 produces a 4x4 array of DCT coefficients for each block. If the block size is 8x8, an 8x8 array of DCT coefficients is produced.

The DCT coefficients for each block are passed to the quantiser 106, where they are quantised using a quantisation parameter QP. Selection of the quantisation parameter QP is controlled by the control manager 160 via control line 115. Quantisation introduces a loss of information, as the quantised coefficients have a lower numerical precision than the coefficients originally generated by the DCT transformation block 104. This provides a further mechanism by which the amount of data required to represent each image of the video sequence can be reduced. However, unlike the DCT transformation, which is essentially lossless, the loss of information introduced by quantisation causes an irreversible degradation in image quality. The greater the degree of quantisation applied to the DCT coefficients, the greater the loss of image quality.

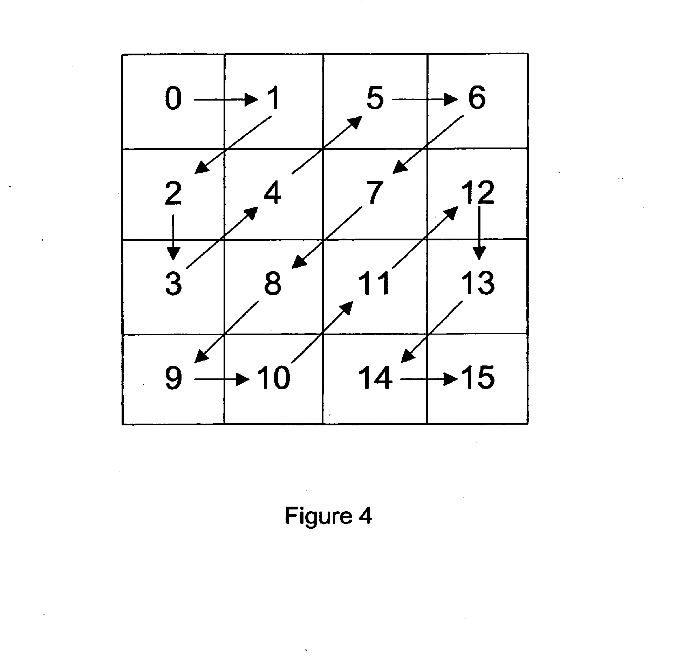

The quantised DCT coefficients for each block are passed from the quantiser 106 to the video multiplex coder 170, as indicated by line 125 in Figure 1. The video multiplex coder 170 orders the quantised transform coefficients for each block using a zigzag scanning procedure. This operation converts the two-dimensional array of quantised transform coefficients into a one-dimensional array. Typical zigzag scanning orders, such as that for a 4x4 array shown in Figure 4, order the coefficients approximately in ascending order of spatial frequency. This also tends to order the coefficients according to their values, such that coefficients positioned earlier in the one-dimensional array are more likely to have larger absolute values than coefficients positioned later in the array. This is because lower spatial frequencies tend to have higher amplitudes within the image blocks. Consequently, values occurring towards the end of the one-dimensional array of quantised transform coefficients tend to be zeros.

Typically, the video multiplex coder 170 represents each non-zero quantised coefficient in the one-dimensional array by two values, referred to as *level* and *run. Level* is the value of the quantised coefficient and *run* is the number of consecutive zero-valued coefficients preceding the coefficient in question. The *run* and *level* values for a given coefficient are ordered such that the *level* value precedes the associated *run* value. A *level* value equal to zero is used to indicate that there are no more non-zero coefficient values in the block. This 0-*level* value is referred to as an EOB (end-of-block) symbol.

Alternatively, each non-zero-valued quantised coefficient in the one-dimensional array can be represented by 3 values *(run, level, last)*. The meaning of *level* and *run* is identical to the previous scheme, whereas *last* denotes if there are any other non-zero-valued coefficients in the one-dimensional array following the current coefficient. Consequently, there is no need for a separate EOB symbol.

The *run* and *level* values *(last* if applicable) are further compressed using entropy coding. Entropy coding is a loss-less operation which exploits the fact that symbols within a data set to be coded generally have different probabilities of occurrence. Therefore, instead of using a fixed number of bits to represent each symbol, a variable number of bits is assigned such that symbols which are more likely to occur are represented by codewords having fewer bits. For this reason, entropy coding is often referred to as Variable Length Coding (VLC). Since certain values of *levels* and *runs* are more likely than other values to occur, entropy coding techniques can be used effectively to reduce the number of bits required to represent the *run* and *level* values.

Once the *run* and *level* values have been entropy coded, the video multiplex coder 170 further combines them with control information, also entropy coded using a variable length coding method appropriate for the kind of information in question, to form a single compressed bit-stream of coded image information 135. It is this bit-stream, including the variable length codewords representative of the (*run, level*) pairs, which is transmitted from the encoder.

While entropy coding has been described in connection with operations performed by the video multiplex coder 170, it should be noted that in alternative implementations a separate entropy coding unit may be provided.

A locally decoded version of the macroblock is also formed in the encoder 100. This is done by passing the quantised transform coefficients for each block, output by quantiser 106, through inverse quantiser 108 and applying an inverse DCT transform in inverse transformation block 110. In this way a reconstructed array of pixel values is constructed for each block of the macroblock. The resulting decoded image data is input to combiner 112. In INTRA-coding mode, switch 114 is set so that the input to the combiner 112 via switch 114 is zero. In this way, the operation performed by combiner 112 is equivalent to passing the decoded image data unaltered.

As subsequent macroblocks of the current frame are received and undergo the previously described encoding and local decoding steps in blocks 104, 106, 108, 110 and 112, a decoded version of the INTRA-coded frame is built up in frame store 120. When the last macroblock of the current frame has been INTRA-coded and subsequently decoded, the frame store 120 contains a completely decoded frame, available for use as a prediction reference frame in coding a subsequently received video frame in INTER-coded format.

Operation of the encoder 100 in INTER-coding mode will now be described. In INTER-coding mode, the control manager 160 operates switch 102 to receive its input from line 117, which comprises the output of combiner 116. The combiner 116 receives the video input signal macroblock by macroblock from input 101. As combiner 116 receives the blocks of luminance and chrominance values which make up the macroblock, it forms corresponding blocks of prediction error information. The prediction error information represents the difference between the block in question and its prediction, produced in motion compensated prediction block 150. More specifically, the prediction error information for each block of the macroblock comprises a two-dimensional array of values, each of which represents the difference between a pixel value in the block of luminance or chrominance information being coded and a decoded pixel value obtained by forming a motion-compensated prediction for the block, according to the procedure described below. Thus, in a situation where each macroblock comprises, for example, an assembly of 4x4 blocks comprising luminance and chrominance values the prediction error information for each block of the macroblock similarly comprises a 4x4 array of prediction error values.

The prediction error information for each block of the macroblock is passed to DCT transformation block 104, which performs a two-dimensional discrete cosine transform on each block of prediction error values to produce a two-dimensional array of DCT transform coefficients for each block. DCT transformation block 104 produces an array of coefficient values for each prediction error block, the number of coefficient values depending on the nature of the blocks which make up the macroblock. For example, if the fundamental block size used in the macroblock is 4x4, DCT transformation block 104 produces a 4x4 array of DCT coefficients for each prediction error block. If the block size is 8x8, an 8x8 array of DCT coefficients is produced.

The transform coefficients for each prediction error block are passed to quantiser 106 where they are quantised using a quantisation parameter QP, in a manner analogous to that described above in connection with operation of the encoder in INTRA-coding mode. Again, selection of the quantisation parameter QP is controlled by the control manager 160 via control line 115.

The quantised DCT coefficients representing the prediction error information for each block of the macroblock are passed from quantiser 106 to video multiplex coder 170, as indicated by line 125 in Figure 1. As in INTRA-coding mode, the video multiplex coder 170 orders the transform coefficients for each prediction error block using the previously described zigzag scanning procedure (see Figure 4) and then represents each non-zero quantised coefficient as a *level* and a *run* value. It further compresses the *run* and *level* values using entropy coding, in a manner analogous to that described above in connection with INTRA-coding mode. Video multiplex coder 170 also receives motion vector information (described in the following) from motion field coding block 140 via line 126 and control information from control manager 160. It entropy codes the motion vector information and control information and forms a single bit-stream of coded image information, 135 comprising the entropy coded motion vector, prediction error and control information.

The quantised DCT coefficients representing the prediction error information for each block of the macroblock are also passed from quantiser 106 to inverse quantiser 108. Here they are inverse quantised and the resulting blocks of inverse quantised DCT coefficients are applied to inverse DCT transform block 110, where they undergo inverse DCT transformation to produce locally decoded blocks of prediction error values. The locally decoded blocks of prediction error values are then input to combiner 112. In INTER-coding mode, switch 114 is set so that the combiner 112 also receives predicted pixel values for each block of the macroblock, generated by motion-compensated prediction block 150. The combiner 112 combines each of the locally decoded blocks of prediction error values with a corresponding block of predicted pixel values to produce reconstructed image blocks and stores them in frame store 120.

As subsequent macroblocks of the video signal are received from the video source and undergo the previously described encoding and decoding steps in blocks 104, 106, 108, 110, 112, a decoded version of the frame is built up in frame store 120. When the last macroblock of the frame has been processed, the frame store 120 contains a completely decoded frame, available for use as a prediction reference frame in encoding a subsequently received video frame in INTER-coded format.

Formation of a prediction for a macroblock of the current frame will now be described. Any frame encoded in INTER-coded format requires a reference frame for motion-compensated prediction. This means, necessarily, that when encoding a video sequence, the first frame to be encoded, whether it is the first frame in the sequence, or some other frame, must be encoded in INTRA-coded format. This, in turn, means that when the video encoder 100 is switched into INTER-coding mode by control manager 160, a complete reference frame, formed by locally decoding a previously encoded frame, is already available in the frame store 120 of the encoder. In general, the reference frame is formed by locally decoding either an INTRA-coded frame or an INTER-coded frame.

The first step in forming a prediction for a macroblock of the current frame is performed by motion estimation block 130. The motion estimation block 130 receives the blocks of luminance and chrominance values which make up the current macroblock of the frame to be coded via line 128. It then performs a block matching operation in order to identify a region in the reference frame which corresponds substantially with the current macroblock. In order to perform the block matching operation, motion estimation block accesses reference frame data stored in frame store 120 via line 127. More specifically, motion estimation block 130 performs block-matching by calculating difference values (e.g. sums of absolute differences) representing the difference in pixel values between the macroblock under examination and candidate best-matching regions of pixels from a reference frame stored in the frame store 120. A difference value is produced for candidate regions at all possible offsets within a predefined search region of the reference frame and motion estimation block 130 determines the smallest calculated difference value. The offset between the macroblock in the current frame and the candidate block of pixel values in the reference frame that yields the smallest difference value defines the motion vector for the macroblock in question.

Once the motion estimation block 130 has produced a motion vector for the macroblock, it outputs the motion vector to the motion field coding block 140. The motion field coding block 140 approximates the motion vector received from motion estimation block 130 using a motion model comprising a set of basis functions and motion coefficients. More specifically, the motion field coding block 140 represents the motion vector as a set of motion coefficient values which, when multiplied by the basis functions, form an approximation of the motion vector. Typically, a translational motion model having only two motion coefficients and basis functions is used, but motion models of greater complexity may also be used.

The motion coefficients are passed from motion field coding block 140 to motion compensated prediction block 150. Motion compensated prediction block 150 also receives the best-matching candidate region of pixel values identified by motion estimation block 130 from frame store 120. Using the approximate representation of the motion vector generated by motion field coding block 140 and the pixel values of the best-matching candidate region of pixels from the reference frame, motion compensated prediction block 150 generates an array of predicted pixel values for each block of the macroblock. Each block of predicted pixel values is passed to combiner 116 where the predicted pixel values are subtracted from the actual (input) pixel values in the corresponding block of the current macroblock. In this way a set of prediction error blocks for the macroblock is obtained.

Operation of the video decoder 200, shown in Figure 2 will now be described. The decoder 200 comprises a video multiplex decoder 270, which receives an encoded video bit-stream 135 from the encoder 100 and demultiplexes it into its constituent parts, an inverse quantiser 210, an inverse DCT transformer 220, a motion compensated prediction block 240, a frame store 250, a combiner 230, a control manager 260, and an output 280.

The control manager 260 controls the operation of the decoder 200 in response to whether an INTRA- or an INTER-coded frame is being decoded. An INTRA / INTER trigger control signal, which causes the decoder to switch between decoding modes is derived, for example, from picture type information provided in a header portion of each compressed video frame received from the encoder. The INTRA / INTER trigger control signal is extracted from the encoded video bit-stream by the video multiplex decoder 270 and is passed to control manager 260 via control line 215.

Decoding of an INTRA-coded frame is performed on a macroblock-by-macroblock basis, each macroblock being decoded substantially as soon as encoded information relating to it is received in the video bit-stream 135. The video multiplex decoder 270 separates the encoded information for the blocks of the macroblock from possible control information relating to the macroblock in question. The encoded information for each block of an INTRA-coded macroblock comprises variable length codewords representing the entropy coded *level* and *run* values for the non-zero quantised DCT coefficients of the block. The video multiplex decoder 270 decodes the variable length codewords using a variable length decoding method corresponding to the encoding method used in the encoder 100 and thereby recovers the *level* and *run* values. It then reconstructs the array of quantised transform coefficient values for each block of the macroblock and passes them to inverse quantiser 210. Any control information relating to the macroblock is also decoded in the video multiplex decoder using an appropriate decoding method and is passed to control manager 260. In particular, information relating to the level of quantisation applied to the transform coefficients is extracted from the encoded bit-stream by video multiplex decoder 270 and provided to control manager 260 via control line 217. The control manager, in turn, conveys this information to inverse quantiser 210 via control line 218. Inverse quantiser 210 inverse quantises the quantised DCT coefficients for each block of the macroblock according to the control information and provides the now inverse quantised DCT coefficients to inverse DCT transformer 220.

Inverse DCT transformer 220 performs an inverse DCT transform on the inverse quantised DCT coefficients for each block of the macroblock to form a decoded block of image information comprising reconstructed pixel values. As motion-compensated prediction is not used in the encoding/decoding of INTRA-coded macroblocks, control manager 260 controls combiner 230 in such a way as to prevent any reference information being used in the decoding of the INTRA-coded macroblock. The reconstructed pixel values for each block of the macroblock are passed to the video output 280 of the decoder where, for example, they can be provided to a display device (not shown). The reconstructed pixel values for each block of the macroblock are also stored in frame store 250. As subsequent macroblocks of the INTRA-coded frame are decoded and stored, a decoded frame is progressively assembled in the frame store 250 and thus becomes available for use as a reference frame for motion compensated prediction in connection with the decoding of subsequently received INTER-coded frames.

INTER-coded frames are also decoded macroblock by macroblock, each INTER-coded macroblock being decoded substantially as soon as encoded information relating to it is received in the bit-stream 135. The video multiplex decoder 270 separates the encoded prediction error information for each block of an INTER-coded macroblock from encoded motion vector information and possible control information relating to the macroblock in question. As explained in the foregoing, the encoded prediction error information for each block of the macroblock comprises variable length codewords representing the entropy coded *level* and *run* values for the non-zero quantised transform coefficients of the prediction error block in question. The video multiplex decoder 270 decodes the variable length codewords using a variable length decoding method corresponding to the encoding method used in the encoder 100 and thereby recovers the *level* and *run* values. It then reconstructs an array of quantised transform coefficient values for each prediction error block and passes them to inverse quantiser 210. Control information relating to the INTER-coded macroblock is also decoded in the video multiplex decoder 270 using an appropriate decoding method and is passed to control manager 260. Information relating to the level of quantisation applied to the transform coefficients of the prediction error blocks is extracted from the encoded bit-stream and provided to control manager 260 via control line 217. The control manager, in turn, conveys this information to inverse quantiser 210 via control line 218. Inverse quantiser 210 inverse quantises the quantised DCT coefficients representing the prediction error information for each block of the macroblock according to the control information and provides the now inverse quantised DCT coefficients to inverse DCT transformer 220. The inverse quantised DCT coefficients representing the prediction error information for each block are then inverse transformed in the inverse DCT transformer 220 to yield an array of reconstructed prediction error values for each block of the macroblock.

The encoded motion vector information associated with the macroblock is extracted from the encoded video bit-stream 135 by video multiplex decoder 270 and is decoded. The decoded motion vector information thus obtained is passed via control line 225 to motion compensated prediction block 240, which reconstructs a motion vector for the macroblock using the same motion model as that used to encode the INTER-coded macroblock in encoder 100. The reconstructed motion vector approximates the motion vector originally determined by motion estimation block 130 of the encoder. The motion compensated prediction block 240 of the decoder uses the reconstructed motion vector to identify the location of a region of reconstructed pixels in a prediction reference frame stored in frame store 250. The reference frame may be, for example, a previously decoded INTRA-coded frame, or a previously decoded INTER-coded frame. In either case, the region of pixels indicated by the reconstructed motion vector is used to form a prediction for the macroblock in question. More specifically, the motion compensated prediction block 240 forms an array of pixel values for each block of the macroblock by copying corresponding pixel values from the region of pixels identified in the reference frame. The prediction, that is the blocks of pixel values derived from the reference frame, are passed from motion compensated prediction block 240 to combiner 230 where they are combined with the decoded prediction error information. In practice, the pixel values of each predicted block are added to corresponding reconstructed prediction error values output by inverse DCT transformer 220. In this way an array of reconstructed pixel values for each block of the macroblock is obtained. The reconstructed pixel values are passed to the video output 280 of the decoder and are also stored in frame store 250. As subsequent macroblocks of the INTER-coded frame are decoded and stored, a decoded frame is progressively assembled in the frame store 250 and thus becomes available for use as a reference frame for motion-compensated prediction of other INTER-coded frames.

Entropy coding of the *run* and *level* values associated with the quantised transform coefficients using the technique of variable length coding (VLC) will now be examined in greater detail.

Typically, a *run-level* pair is encoded as a single symbol. This is achieved by defining a mapping between each possible *run-level* pair and the defined code numbers. An example of a mapping of *run-level* pairs to code numbers as a look up table, as illustrated in Table 3. Using the mappings in the look-up table, a code number is assigned to each *(run, level)* pair of the block and the resulting code numbers are encoded by VLC coding. For example, in Joint Model (JM) 2.0 "Working Draft Number 2, Doc. JVT-B118, Joint Video Team (JVT) of ISO/IEC MPEG and ITU-T VCEG Pattaya, 2nd JVT Meeting, Geneva, CH, Jan. 29 - Feb. 1, 2002", (H.26L video coding standard) two different look-up tables are defined that map the *(run, level)* pairs onto code numbers. The selection of which table is to be used is based on the QP value and the coding mode of the block. More specifically, if the coding mode is INTRA and the QP is smaller than 24, a different table is used than otherwise.

The US patent 5,640,420 discloses a variable length coder using two VLC tables. The encoder converts the input signal to DCT coefficients, quantizes the coefficients and produces two subsets of a set of quantized transform coefficients. The first subset comprises quantized coefficients, which represent low frequency components of the input signal. Respectively, the second subset comprises quantized coefficients, which represent high frequency components of the input signal. The first subset is further converted into a first set of one or more RLC codes and the second subset is converted into a second set of one or more RLC codes. The encoder codes each RLC code of the first and second sets to generate a first and a second sets of one or more VLC codewords. The selection in which subset a quantized coefficient belongs is simply made by dividing the zig-zag -scanning process into two parts: the coefficients having a scanning order less than a threshold N belongs to the first subset and all the remaining coefficients belong to the second subset. The values of the coefficients do not affect to the selection to which subset each coefficient belongs. Therefore, also the selection of the VLC table is not dependent on the values of the coefficients.

The document Detlev Marpe, Gabi Blättermann and Thomas Wiegand "Improved CABAC", VCEG-018, ITU - Telecommunications Standardization Sector, STUDY GROUP 16 Question 6, Video Coding Experts Group (VCEG), 15th Meeting: Pattaya, Thailand, 4-6 Dec., 2001, discloses a method how to reduce the amount of information needed to transmit the Run-Level-Sign information. It is based on truncation of code words which are used to encode the Run value. The truncation can be performed when it is assured that only a certain number of indices are needed to encode the Run value. As an example, if the COEFF_COUNT is 9 and the block to be encoded comprises 16 coefficients, the maximum Run value (maxrun) is then 7. From the Table 1 it can be deduced that the last bit of the prefix of the index 7 (1110) need not be transmitted because all the indices smaller than 7 do not begin with 111. Also a new value for the maxrun is updated on the basis of the current Run value.

This document also discloses that the values of the number of coefficients from the neighboring blocks is used to design context models to increase coding efficiency while coding the number of coefficient value of the present block. More specifically, if A and B denote the COEFF_COUNTs of the block to the left and on top of a given block, then the context model $ctx\_coeff\_count(C)$ of the actual COEFF_COUNT symbol C is defined by $ctx\_coeff\_count(C) = ((A==0)?0:1) + 2*((B==0)?0:1)$.

Joint Model JM 2.0 of JVT H.26L makes use of a so-called 'universal' variable length coding scheme, referred to as UVLC. Accordingly, a video encoder implemented according to H.26L JM 2.0 uses a single set of variable length codewords to entropy code all information (syntax elements) to be transmitted in the bit-stream from the encoder. While the codewords used are the same, a predetermined number of different data-symbol-to-codeword mappings are defined for the coding of different types of information. For example, two data-symbol-to-codeword mappings are provided for blocks containing luminance information, the choice of mapping depending on the type of zigzag scanning operation (simple or double scan) used to order the quantised DCT transform coefficients. For details of the simple and double scan zigzag scanning schemes defined according to H.26L, see Working Draft Number 2, Doc. JVT-B118, Joint Video Team (JVT) of ISO/IEC MPEG and ITU-T VCEG Pattaya, 2nd JVT Meeting, Geneva, CH, Jan. 29 - Feb. 1, 2002. Different mappings are also provided for macroblock type (MB_Type) information, motion vector data (MVD) and INTRA-prediction mode information, among others (see Table 3, below).

The UVLC codewords defined in H.26L JM 2.0 may be written in the following compressed form, shown in Table 1 below, where the $x_n$ terms can take either the value 0 or 1:

Table 1: Scheme for Generation of UVLC Codewords According to H.26L

|   |   |   |   | 1 |   |   |   |   |
|---|---|---|---|---|---|---|---|---|
|   |   |   | 0 | 1 | $x_0$ |   |   |   |
|   |   | 0 | 0 | 1 | $x_1$ | $x_0$ |   |   |
|   | 0 | 0 | 0 | 1 | $x_2$ | $x_1$ | $x_0$ |   |
| 0 | 0 | 0 | 0 | 1 | $x_3$ | $x_2$ | $x_1$ | $x_0$ |

Table 2 presents the first 16 UVLC codewords, generated according to the scheme presented in Table 1, while Table 3 shows some of the different data-symbol-to-codeword mappings provided according to H.26L. For a complete description of the mappings, the reader should again refer to Working Draft Number 2, Doc. JVT-B118, Joint Video Team (JVT) of ISO/IEC MPEG and ITU-T VCEG Pattaya, 2nd JVT Meeting, Geneva, CH, Jan. 29-Feb. 1, 2002.

Table 2: The First 16 UVLC Codewords of H.26L Generated According to the Scheme Presented in Table 1

| Codeword index | VLC Codeword |
|---|---|
| 0 | 1 |
| 1 | 010 |
| 2 | 011 |
| 3 | 00100 |
| 4 | 00101 |
| 5 | 00110 |
| 6 | 00111 |
| 7 | 0001000 |
| 8 | 0001001 |
| 9 | 0001010 |
| 10 | 000010000 |
| 11 | 000010001 |
| 12 | 000010010 |
| 13 | 000010011 |
| 14 | 000010100 |
| 15 | 000010101 |
| .... | .... |

Table 3: Example Data-Symbol-to-UVLC-Codeword Mappings as Defined in H.26L TML-5

| Code_ number | MB_Type | | INTRA_ prediction_ mode | | MVD | Tcoeff_chroma_AC Tcoeff_luma Simple scan | | Tcoeff_luma Double scan | |
|---|---|---|---|---|---|---|---|---|---|
| | INTRA | INTER | Prob0 | Prob1 | | Level | Run | Level | Run |
| 0 | Intra4x4 | Skip | 0 | 0 | 0 | EOB | - | EOB | - |
| 1 | 0,0,0[3] | 16x16 | 1 | 0 | 1 | 1 | 0 | 1 | 0 |
| 2 | 1,0,0 | 8x8 | 0 | 1 | -1 | -1 | 0 | -1 | 0 |
| 3 | 2,0,0 | 16x8 | 0 | 2 | 2 | 1 | 1 | 1 | 1 |
| 4 | 3,0,0 | 8x16 | 1 | 1 | -2 | -1 | 1 | -1 | 1 |
| 5 | 0,1,0 | 8x4 | 2 | 0 | 3 | 1 | 2 | 2 | 0 |
| 6 | 1,1,0 | 4x8 | 3 | 0 | -3 | -1 | 2 | -2 | 0 |
| 7 | 2,1,0 | 4x4 | 2 | 1 | 4 | 2 | 0 | 1 | 2 |
| 8 | 3,1,0 | Intra4x4 | 1 | 2 | -4 | -2 | 0 | -1 | 2 |
| 9 | 0,2,0 | 0,0,0[3] | 0 | 3 | 5 | 1 | 3 | 3 | 0 |
| 10 | 1,2,0 | 1,0,0 | 0 | 4 | -5 | -1 | 3 | -3 | 0 |
| 11 | 2,2,0 | 2,0,0 | 1 | 3 | 6 | 1 | 4 | 4 | 0 |
| 12 | 3,2,0 | 3,0,0 | 2 | 2 | -6 | -1 | 4 | -4 | 0 |
| 13 | 0,0,1 | 0,1,0 | 3 | 1 | 7 | 1 | 5 | 5 | 0 |
| 14 | 1,0,1 | 1,1,0 | 4 | 0 | -7 | -1 | 5 | -5 | 0 |
| 15 | 2,0,1 | 2,1,0 | 5 | 0 | 8 | 3 | 0 | 1 | 3 |
| 16 | 3,0,1 | 3,1,0 | 4 | 1 | -8 | -3 | 0 | -1 | 3 |

(continued)

| Code_number | MB_Type | | INTRA_prediction_mode | | MVD | Tcoeff_chroma_AC Tcoeff_luma Simple scan | | Tcoeff_luma Double scan | |
|---|---|---|---|---|---|---|---|---|---|
| | INTRA | INTER | Prob0 | Prob1 | | Level | Run | Level | Run |
| 17 | 0,1,1 | 0,2,0 | 3 | 2 | 9 | 2 | 1 | 1 | 4 |
| 18 | 1,1,1 | 1,2,0 | 2 | 3 | -9 | -2 | 1 | -1 | 4 |
| 19 | 2,1,1 | 2,2,0 | 1 | 4 | 10 | 2 | 2 | 2 | 1 |
| 20 | 3,1,1 | 3,2,0 | 0 | 5 | -10 | -2 | 2 | -2 | 1 |
| 21 | 0,2,1 | 0,0,1 | 1 | 5 | 11 | 1 | 6 | 3 | 1 |
| 22 | 1,2,1 | 1,0,1 | 2 | 4 | -11 | -1 | 6 | -3 | 1 |
| 23 | 2,2,1 | 2,0,1 | 3 | 3 | 12 | 1 | 7 | 6 | 0 |
| 24 | 3,2,1 | 3,0,1 | 4 | 2 | -12 | -1 | 7 | -6 | 0 |
| 25 | | 0,1,1 | 5 | 1 | 13 | 1 | 8 | 7 | 0 |
| 26 | | 1,1,1 | 5 | 2 | -13 | -1 | 8 | -7 | 0 |
| 27 | | 2,1,1 | 4 | 3 | 14 | 1 | 9 | 8 | 0 |
| 28 | | 3,1,1 | 3 | 4 | -14 | -1 | 9 | -8 | 0 |
| 29 | | 0,2,1 | 2 | 5 | 15 | 4 | 0 | 9 | 0 |
| 30 | | 1,2,1 | 3 | 5 | -15 | -4 | 0 | -9 | 0 |
| 31 | | 2,2,1 | 4 | 4 | 16 | 5 | 0 | 10 | 0 |
| 32 | | 3,2,1 | 5 | 3 | -16 | -5 | 0 | -10 | 0 |
| 33 | | | 5 | 4 | 17 | 3 | 1 | 4 | 1 |
| 34 | | | 4 | 5 | -17 | -3 | 1 | -4 | 1 |
| 35 | | | 5 | 5 | 18 | 3 | 2 | 2 | 2 |
| 36 | | | | | -18 | -3 | 2 | -2 | 2 |
| 37 | | | | | 19 | 2 | 3 | 2 | 3 |
| 38 | | | | | -19 | -2 | 3 | -2 | 3 |
| 39 | | | | | 20 | 2 | 4 | 2 | 4 |
| 40 | | | | | -20 | -2 | 4 | -2 | 4 |
| 41 | | | | | 21 | 2 | 5 | 2 | 5 |
| 42 | | | | | -21 | -2 | 5 | -2 | 5 |
| 43 | | | | | 22 | 2 | 6 | 2 | 6 |
| 44 | | | | | -22 | -2 | 6 | -2 | 6 |
| 45 | | | | | 23 | 2 | 7 | 2 | 7 |
| 46 | | | | | -23 | -2 | 7 | -2 | 7 |
| 47 | | | | | 24 | 2 | 8 | 11 | 0 |
| .. | | | | | .. | .. | .. | .. | .. |

The universal variable length coding scheme adopted in H.26L provides a number of technical advantages. In particular, use of a single set of VLC codewords, which can be constructed according to a simple rule, such as that presented in Table 1, enables codewords to be created bit-by-bit. This obviates the need for storage of a codeword table in the encoder and decoder and thus reduces the memory requirements of both the encoder and decoder. It should be noted, of course, that in alternative implementations, codeword tables may be generated and stored in the encoder and decoder. The different data-symbol-to-codeword mappings allow at least limited adaptation of the UVLC coding scheme to the different statistical properties of the various types of image-related data and control information that are entropy coded. The various data-symbol-to-codeword mappings can be stored in the encoder and decoder and thus there is no need to transmit the mapping information in the bit-stream from encoder to decoder. This helps maintain error resilience.

The UVLC entropy coding scheme does, however, also suffer from some disadvantages. In particular, the fixed codewords and the limited degree of adaptability provided by the different data-symbol-to-codeword mappings, inevitably result in less than optimum data compression. This is due to the fact that, in image coding, the frequency of occurrence (i.e. probability) of different transform coefficients, and hence the probability of different *(run, level)* pairs, changes depending on the image content and the type of the image being encoded. Thus, if a single set of variable length codewords is used and only a single mapping between the data symbols to be encoded/decoded and the VLCs is provided, in general, optimum coding efficiency cannot be achieved.

For this reason modifications of the basic UVLC coding scheme have been proposed. More specifically, it has been suggested to include more than one set of VLC codewords. One such proposal was made by Gisle Bjontegaard in Q.15/SG16 "Use of Adaptive Switching Between Two VLCs for INTRA Luma Coefficients", Doc. Q15-K-30, August 2000. This proposal suggested the use of a second set of VLC codewords for the entropy coding of certain types of information. According to document Q15-K-30, the proposed second set of VLC codewords, referred to as VLC2, is constructed according to the scheme shown below in Table 4. It is used in particular to code the *run* and *level* values associated with quantised transform coefficients of 4x4 pixel INTRA-coded luminance blocks scanned using the double scan zigzag scanning scheme defined according to H.26L. Table 5 shows, in explicit form, the first 16 codewords of VLC2.

Table 4: Scheme for Generation of VLC2 Codewords According to Q.15/SG16 Document Q15-K-30

| | | | | 1 | | 0 | | | |
|---|---|---|---|---|---|---|---|---|---|
| | | | 1 | | 1 | | 0 | | |
| | | | 1 | | 1 | | 1 | | |
| | | 0 | | 1 | | $x_1$ | $x_0$ | | |
| | 0 | 0 | | 1 | | $x_2$ | $x_1$ | $x_0$ | |
| 0 | 0 | 0 | | 1 | | $x_3$ | $x_2$ | $x_1$ | $x_0$ |

Table 5: The First 16 VLC2 Codewords of Q.15/SG16 Document Q15-K-30, Generated According to the Scheme Presented in Table 4

| Codeword Index | VLC2 Codeword |
|---|---|
| 0 | 10 |
| 1 | 110 |
| 2 | 111 |
| 3 | 0100 |
| 4 | 0101 |
| 5 | 0110 |
| 6 | 0111 |
| 7 | 001000 |
| 8 | 001001 |
| 9 | 001010 |
| 10 | 001011 |
| 11 | 001100 |
| 12 | 001101 |
| 13 | 001110 |
| 14 | 001111 |
| 15 | 00010000 |

As can be seen by comparing Tables 4 and 5 with Tables 1 and 2 respectively, the shortest codeword of VLC2 has two bits as opposed to the single bit allocated to the shortest codeword in the original set of UVLC codewords. Due to the general decodability requirement that no VLC codeword may be a prefix of any other, this change has a significant effect on the structure of the other VLC2 codewords. In particular, assigning two bits to the shortest codeword enables codewords having higher indices to be represented with fewer bits. For example, referring to Table 2, it can be seen that the UVLC codeword with index 7 has 7 bits, while the VLC2 codeword with index 7 has only 6 bits.

The previously described methods of VLC coding in which codewords are selected by context-based switching between more than one set of codewords, provide an improvement in data compression efficiency compared with methods in which a single set of VLC codewords is used. However, in many data compression applications, and particularly in applications related to video coding, there is a continuing desire to improve data compression efficiency. Thus, there is still considerable interest in the development of new methods of variable length coding which provide improved adaptability to the type and statistical properties of the data symbols to be coded while maintaining low computational complexity, low memory requirements and good error resilience. It is in this context that the method according to the present invention has been developed.

Summary of the Invention

The method according to the present invention seeks to address the aforementioned problems relating to improving the adaptability of variable length coding methods to the type and statistical properties of the data symbols to be coded while maintaining low computational complexity and good error resilience.

In general terms, the invention relates to the variable length coding of quantised transform coefficients produced as a result of block-based transform coding in a video encoder. It should be appreciated, however, that the variable length encoding and decoding methods according to the invention may be applied more generally to other types of data to be coded. In particular, the invention relates to a method of VLC coding in which the number of non-zero-valued coefficients $N_c$ in a block of quantised transform coefficients is identified and signalled explicitly in the bit-stream transmitted to a corresponding decoder. As previously explained, explicit signalling of $N_c$ obviates the need to send an EOB symbol and this can give rise to an improvement in coding efficiency. More specifically, the invention proposes a method by which the $N_c$ value representing the number of non-zero-valued coefficients in a block is itself VLC coded. This provides a still greater improvement in coding efficiency.

The method involves the use of at least two sets of VLC codewords to VLC encode the value for $N_c$ and defines rules for switching between the sets of codewords, which take into account the number of non-zero-valued coefficients in a block (or blocks) neighbouring the block to be whose $N_c$ value is to be coded. The switching rules are designed so that a bit-stream comprising VLC codewords representative of $N_c$ and formed according to the inventive method can be decoded without requiring any information relating to the choice of codewords to be included in the bit-stream. In other words, according to the invention, there is no need to provide an explicit indication of the set from which each codeword representative of an $N_c$ value was chosen. This property enhances data compression efficiency.

Those skilled in the art will appreciate that the method according to the invention can be applied in general to the VLC coding of data symbols which are represented as *(run, level)* pairs or to any equivalent representation of the set of data symbols to be encoded.

According to a first aspect of the invention, there is provided a method of encoding a set of data symbols comprising a certain first number of data symbols having a first value and a certain second number of data symbols having values other than said first value, in which a set of symbols to be variable-length encoded is formed from said set of data symbols, and variable-length encoding is applied to the set of symbols to be variable-length encoded. According to the method, at least one characteristic of the variable length encoding applied to the set of symbols to be variable-length encoded is adapted according to the number of the symbols to be variable-length encoded and an indication of the number of variable-length encoded symbols is provided. Advantageously, the indication is a variable length codeword representative of the number of symbols to be variable length encoded selected from one of at least two alternative sets of variable length codewords according to the number of symbols to be variable length encoded.

According to a second aspect of the invention, there is provided a method of decoding variable length codewords representing a set of data symbols, the set of data symbols comprising a certain first number of data symbols having a first value and a certain second number of data symbols having values other than said first value, the set of data symbols having been encoded by forming a set of data symbols to be variable-length encoded from said set of data symbols, said variable length codewords having been formed by applying variable-length encoding to the set of symbols to be variable-length encoded. According to the method, at least one characteristic of the decoding applied to the variable length codewords is adapted according to an indication of the number of symbols in the set of symbols that were variable-length encoded. Advantageously, the indication is a variable length codeword representative of the number of symbols that were variable length encoded selected from one of at least two alternative sets of variable length codewords according to the number of symbols that were variable length encoded.

According to a third aspect of the invention, there is provided an encoder for encoding a set of data symbols comprising a certain first number of data symbols having a first value and a certain second number of data symbols having values other than said first value, in which a set of symbols to be variable-length encoded is arranged to be formed from said set of data symbols, and the encoder comprises encoding means for variable-length encoding said set of symbols to be variable-length encoded. According to the invention, the encoder is arranged to adapt at least one characteristic of the variable length encoding applied to the set of symbols to be variable-length encoded according to the number of the symbols to be variable-length encoded and is further arranged to provide an indication of the number of variable-length encoded symbols. Advantageously, the indication is a variable length codeword representative of the number of symbols to be variable length encoded selected from one of at least two alternative sets of variable length codewords according to the number of symbols to be variable length encoded.

According to a fourth aspect of the invention, there is provided a decoder for decoding variable length codewords representing a set of data symbols, the set of data symbols comprising a certain first number of data symbols having a first value and a certain second number of data symbols having values other than said first value, the set of data symbols having been encoded by forming a set of symbols to be variable-length encoded and said variable length codewords having been formed by applying variable-length encoding to said set of symbols to be variable-length encoded. According to the invention, the decoder is arranged to adapt at least one characteristic of the decoding applied to the variable length codewords according to an indication of the number of symbols in the set of symbols that were variable-length encoded. Advantageously, the indication is a variable length codeword representative of the number of symbols that were variable length encoded selected from one of at least two alternative sets of variable length codewords according to the number of symbols that were variable length encoded.

According to a fifth aspect of the invention, there is provided a multimedia terminal comprising an encoder according the third aspect of the invention. According to a sixth aspect of the invention, there is provided a multimedia terminal comprising a decoder according to the fourth aspect of the invention.

Preferably, the multimedia terminal according to the fifth and / or sixth aspects of the invention is a mobile multimedia terminal arranged to communicate with a mobile telecommunications network by means of a radio connection.

To put it more precisely, the encoding method according to the present invention is primarily characterized as defined by claim 1. The decoding method according to the present invention is primarily characterized as defined by claim 11. The encoder according to the present invention is primarily characterized as defined by claim 20. The decoder according to the present invention is primarily characterized as defined by claim 32.

Brief Description of the Drawings

Embodiments of the invention will now be described by example with reference to the appended drawings, in which:

Figure 1     is a schematic block diagram of a generic video encoder according to prior art;
Figure 2     is a schematic block diagram of a generic video decoder according to prior art and corresponding to the encoder shown in Figure 1;
Figure 3     illustrates the formation of a macroblock according to prior art;
Figure 4     illustrates an exemplary zigzag scanning order;
Figure 5     shows a current image block to be coded and its immediately neighbouring, previously encoded image blocks;
Figure 6     is a schematic block diagram of a video encoder according to an embodiment of the invention
Figure 7     is a schematic block diagram of a video decoder according to an embodiment of the invention and corresponding to the encoder shown in Figure 6; and
Figure 8     is a schematic block diagram of a multimedia communications terminal in which the method according to the invention may be implemented.

Detailed Description of the Invention

In the detailed description of the invention which follows, an exemplary embodiment of the method according to the invention is presented. The exemplary embodiment relates to the variable length coding of (run, level) pairs representing non-zero-valued transform coefficient produced as a result of block-based transform coding in a video encoder, as well as their subsequent decoding in a corresponding video decoder.

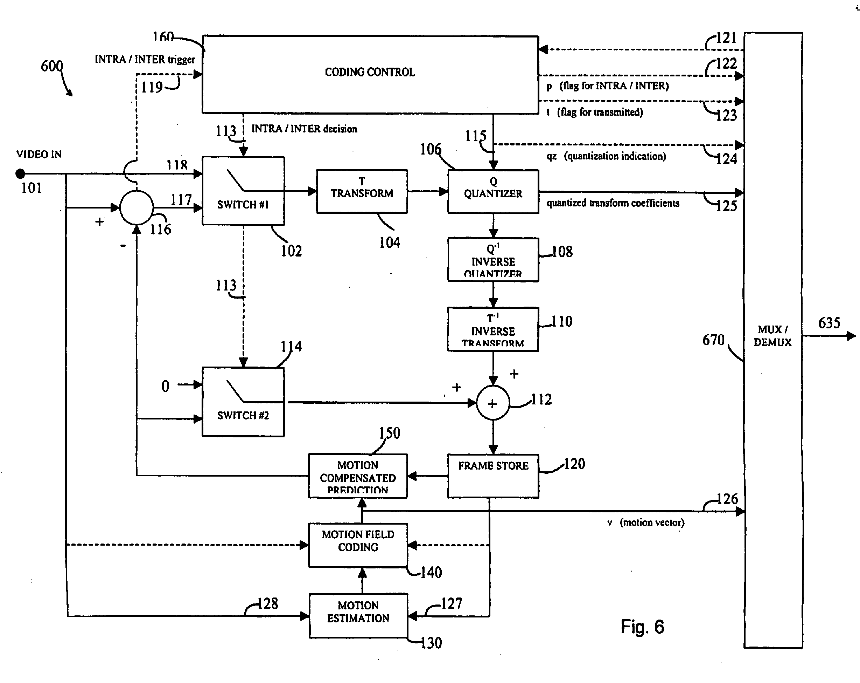

Figure 6 is a schematic block diagram of a video encoder 600 in which the method according to this embodiment of the invention may be applied. The structure of the video encoder shown in Figure 6 is substantially identical to that of the prior art video encoder shown in Figure 1, with appropriate modifications to those parts of the encoder which perform variable length coding operations. All parts of the video encoder which implement functions and operate in a manner identical to the previously described prior art video encoder are identified with identical reference numbers. In this description it will be assumed that all variable length coding operations are performed in video multiplex coder 670. However, it should be appreciated that in alternative embodiments of the invention a separate variable length coding unit or units may be provided. It should also be noted that the method according to the invention may be applied to certain of the data symbols produced by the video encoder (e.g. the (run, level) pairs associated with non-zero-valued transform coefficients) and other VLC coding methods may be used to encode other data symbols.

Operation of the video encoder 600 will now be considered in detail. When encoding a frame of digital video, encoder 600 operates in a manner similar to that previously described in connection with Figure 1 to generate INTRA-coded and INTER-coded compressed video frames. As explained earlier in the text, in INTRA-coding mode, a Discrete Cosine Transform (DCT) is applied to each block of image data (pixel values) in order to produce a corresponding two-dimensional array of transform coefficient values. The DCT operation is performed in transform block 104 and the coefficients thus produced are subsequently passed to quantiser 106, where they are quantised. In INTER-coding mode, the DCT transform performed in block 104 is applied to blocks of prediction error values. The transform coefficients produced as a result of this operation are also passed to quantiser 106 where they too are quantised. INTER-coded frames may contain INTRA-coded image blocks. In some situations transform coding is not applied to particular image blocks. For example, if INTRA-prediction is used in INTRA-coding mode, some image blocks are predicted in the encoder from one or more previously encoded image block. In this case the encoder provides the decoder with an indication of the previous blocks to be used in the prediction and does not output any transform coefficient data. In INTER-coding mode, the difference between the prediction for a certain block and the image data of the block itself may be so small that it is advantageous in terms of data compression ratio not to transmit any prediction error information.

According to this embodiment, the method according to the invention is applied to those image blocks which undergo transform coding and subsequent transform coefficient quantisation.

When video multiplex coder 670 receives a block (two-dimensional array) of quantised transform coefficients, it determines the number of non-zero-valued coefficients in the array. According to the invention, this number, referred to as $N_c$, is variable length coded and transmitted to the decoder in bit-stream 635. At least two sets of variable length codewords are provided for variable length coding of the $N_c$ value. In an embodiment of the invention, these are, for example, the VLC codewords defined respectively in Tables 2 and 5, previously described in the text. More specifically, $N_c$ is variable length encoded using a codeword selected from one of the at least two sets of variable length codewords responsive to the values of previously coded $N_c$ symbols. Advantageously, the previously coded $N_c$ symbols used to assign the VLC codewords are chosen from blocks that reside close to the block being coded.

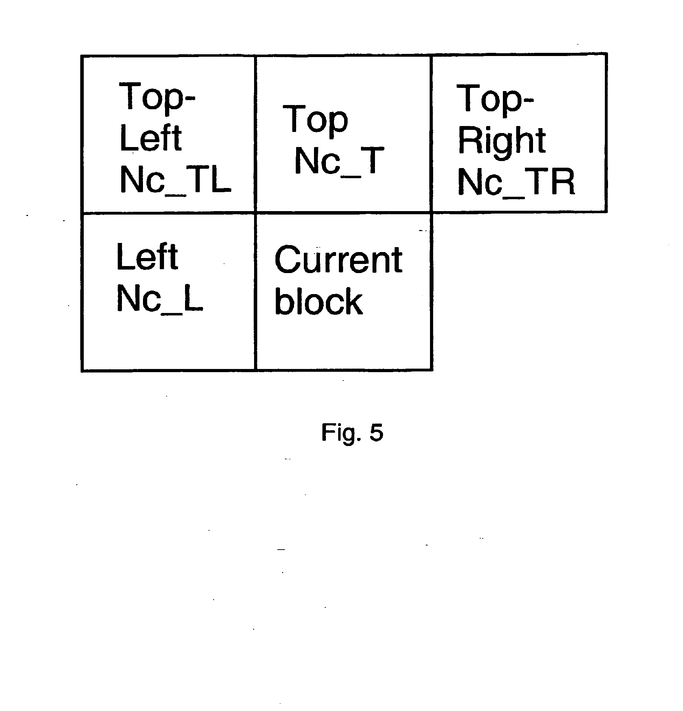

Figure 5 depicts an image block to be VLC encoded and its neighboring blocks. The terms $N_c\_L$, $N_c\_TL$, $N_c\_T$ and $N_c\_TR$ denote respectively the number of non-zero quantized coefficients in blocks to the Left, Top-Left, Top and Top-Right of the current image block to be encoded.

The $N_c$ value for the current image block is variable length encoded using a codeword from one of the available sets of VLC codes, chosen by considering the already coded $N_c$ value(s) of immediately neighboring block(s). The following code presents an exemplary procedure for assigning a variable length code to an $N_c$ value, taking into account the $N_c$ values of the previously encoded neighbouring image blocks:

$$VLC\_N = N_c\_map[fn(N_c\_L, N_c\_TL, N_c\_T, N_c\_TR)] \qquad (1)$$

In expression (1), fn is a function (an example of which is defined below in equation (2)), $N_c\_map$ is an array that maps integer values to different available VLC codes and VLC_N indicates the number of the table from which the codewords are to selected. Examples of fn include "average" and "median". In an embodiment of the invention, the "average" of $N_c\_L$ and $N_c\_T$ is used. According to this exemplary embodiment, the assignment presented in expression (1) becomes:

$$VLC\_N = N_c\_map[(N_c\_L + N_c\_T) / 2] \qquad (2)$$

The following example further illustrates the encoding of $N_c$ according to the method of the invention. Assume that the current $N_c$ value to be encoded is 3, the neighboring $N_c\_L$ and $N_c\_T$ values are given by 4 and 2, respectively and $N_c\_map$ is given by $N_c\_map=[1\ 1\ 1\ 1\ 1\ 2\ 2\ 2\ 2]$ where VLC1 and VLC2 correspond to the codewords from Table 2 and Table 5, respectively. Applying equation (2), VLC_N is equal to 1. In this case $N_c = 3$ is encoded as 00100 using the VLC codewords from Table 2.

The video multiplex coder 670 next represents the non-zero-valued coefficients as *(run, level)* pairs. This may be done in a manner known from prior art. More specifically, the two-dimensional array of quantised transform coefficients is first scanned using a predefined scanning order, such as that shown in Figure 4, to produce an ordered one-dimensional array. Each non-zero coefficient value in the ordered one-dimensional array is then represented by a *run* value and a *level* value, where the *level* value represents the value of the coefficient and the *run* value represents the number of consecutive zero-valued coefficients preceding the non-zero-valued coefficient. Unlike the prior art method of run-length coding previously described, according to the method of the invention, an EOB symbol does not need to be transmitted. The possibility not to transmit an EOB symbol arises because, according to the method of the invention, the number of non-zero-valued quantised transform coefficients is indicated explicitly to the decoder. Thus, when decoding *(run, level)* pairs for a given image block, the decoder can count the number of decoded pairs. When the number of decoded pairs (corresponding to the number of non-zero-valued coefficients) reaches the number of non-zero-valued coefficients indicated to the decoder, decoding for the block in question can be stopped.

The video multiplex coder 670 then applies variable length coding to the *run* and *level* values in such a way that a single VLC codeword is assigned to each *(run, level)* pair. According to the invention, VLC coding is performed by selecting one of a set of variable length coding (look-up) tables stored in the encoder 600. Each of the coding tables defines a set of variable length codewords, as well as a mapping between the codewords and the possible values of *(run, level)* pairs which may arise in the quantised transform coefficient data for an image block. According to the invention, the video multiplex coder 670 selects a coding table for use according to the number of non-zero-valued coefficients in the array of quantised transform coefficients for the image block being coded. Using the mappings defined in the selected look-up table, the video multiplex coder assigns a codeword to each *(run, level)* pair and transmits the codeword to the decoder in the bit-stream 635.

The number of different VLC coding tables may vary in different embodiments of the invention. In one embodiment of the invention, a separate look-up table is provided for each possible number of non-zero-valued quantised transform coefficients. The codewords and the mappings between the *(run, level)* pairs and the codewords for each one of the tables are designed to provide optimum data compression when applied to a set of *(run, level)* pairs derived from an array of quantised transform coefficient values having a specified number of non-zero-valued coefficients. Information about the variation of the statistical properties of the *(run, level)* pairs with respect to the number of non-zero-valued quantised transform coefficients may be obtained empirically, for example, by coding a number of test ('training') images or video sequences in advance. The VLC codewords and the mappings between the codewords can then be designed and stored as one or more look-up table in the encoder.

In a preferred embodiment, for use in coding *(run, level)* pairs derived from 4x4 image blocks, only two VLC coding tables are provided, one for use when the number of non-zero-valued quantised transform coefficients is smaller than or equal to 8 and one to be used when the number of non-zero-valued quantised transform coefficients is greater than 8. Tables 6 and 7 illustrate the different probability distributions of *(run, level)* pairs in this embodiment of the invention. The statistics were gathered using a video encoder implemented according to Test Model 8 (TML8) of the current ITU-T recommendation H.26L and relate to INTER-coded image blocks. In the tables, the most probable pair is assigned number 1, the second most probable pair number 2, etc. The first 15 most probable pairs are listed.

Table 6: Probabilities of *(run, level)* pairs when the number of non-zero-valued quantised coefficients is smaller than or equal to 8 (4x4 INTER-coded block).

| | | run | | | | | | | | | |
|---|---|---|---|---|---|---|---|---|---|---|---|
| | | 0 | 1 | 2 | 3 | 4 | 5 | 6 | 7 | 8 | 9 |
| level amplitude | 1 | 1 | 2 | 3 | 4 | 6 | 7 | 8 | 11 | 12 | 15 |
| | 2 | 5 | 10 | 13 | | | | | | | |
| | 3 | 9 | | | | | | | | | |
| | 4 | 14 | | | | | | | | | |

Table 7: Probabilities of *(run, level)* pairs when the number of non-zero-valued quantised coefficients is greater than 8 (4x4 INTER-coded block).

| | | run | | | |
|---|---|---|---|---|---|
| | | 0 | 1 | 2 | 3 |
| level amplitude | 1 | 1 | 3 | 5 | 9 |
| | 2 | 2 | 7 | 12 | |
| | 3 | 4 | 10 | | |
| | 4 | 6 | 14 | | |
| | 5 | 8 | | | |
| | 6 | 11 | | | |
| | 7 | 13 | | | |
| | 8 | 15 | | | |

In an alternative embodiment of the invention the coding efficiency can be improved by changing the type of symbols transmitted. Instead of representing the quantised transform coefficients as *(run, level)* pairs, they are represented by a *(level, last)* pairs and a VLC codeword is assigned to each of the *(level, last)* pairs. The *level* of a *(level, last)* pair represents the value of the coefficient, but unlike *(run, level)* pairs previously described, it can take the value 0. The *last* parameter is used to indicate that there are no more non-zero-valued coefficients in the block. For example, it can be used as a binary flag, such that if the *level* value of a particular coefficient is zero and all following coefficient values are zero, *last* is set equal to 1. This alternative representation of the quantised transform coefficients can provide an improvement in coding efficiency (data compression) particularly for INTRA-coded blocks and in situations where small QP values are used.

In another alternative embodiment of the invention, a fixed set of VLC codewords is used and only the mapping between the codewords and the *(run, level)* pairs to be encoded changes in dependence upon the number of non-zero-valued coefficients.

In a further alternative embodiment of the invention, the VLC coding table chosen for a particular image block may also be dependent on some other parameter, such as the value of the quantisation parameter (QP) used to quantise the transform coefficients of an image block or the type of frame or image block (INTRA / INTER). In this case choice of a VLC coding table for a particular array of quantised transform coefficients depends on both the number of non-zero-valued coefficients and the value of the other parameter.

In yet another alternative embodiment of the invention, the number of zero-valued quantised transform coefficient values may be determined and used as the parameter according to which VLC codewords and mappings between the codewords and data symbols are designed and VLC look-up tables are selected.

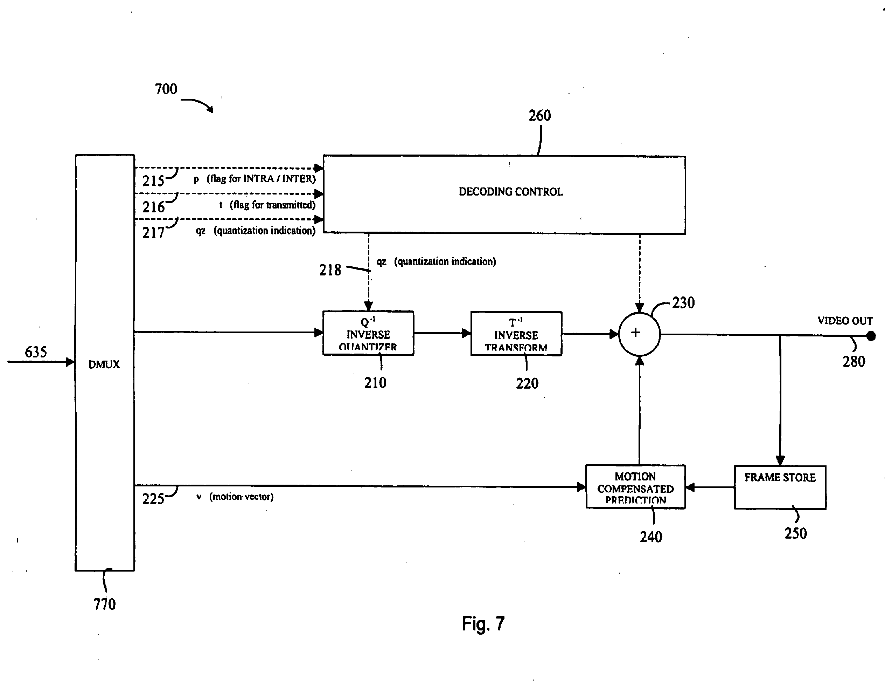

Operation of a video decoder 700 according to an embodiment of the invention will now be described with reference to Figure 7. The structure of the video decoder illustrated in Figure 7 is substantially identical to that of the prior art video decoder shown in Figure 2, with appropriate modifications to those parts of the decoder which perform variable length decoding operations. All parts of the video decoder which implement functions and operate in a manner identical to the previously described prior art video decoder are identified with identical reference numbers. In the description which follows it is assumed that all variable length decoding operations are performed in video multiplex decoder 770. However, it should be appreciated that in alternative embodiments of the invention a separate variable length decoding unit or units may be provided.

Operation of the video decoder will now be described in detail. Here it is assumed that the video decoder of Figure 7 corresponds to the encoder described in connection with Figure 6 and is therefore capable of receiving and decoding the bit-stream 635 transmitted by encoder 600. In the decoder, the bit-stream is received and separated into its constituent parts by video multiplex decoder 770. As explained in connection with the earlier description of prior art, the compressed video data extracted from the bit-stream is processed on a macroblock-by-macroblock basis. The compressed video data for an INTRA-coded macroblock comprises variable length codewords representing the VLC coded $N_c$ value and *(run, level)* pairs for each block of the macroblock, together with encoded control information (for example, relating to quantisation parameter QP). The compressed video data for an INTER-coded macroblock comprises VLC encoded prediction error information for each block (comprising a VLC coded $N_c$ value and VLC coded *(run, level)* pairs), motion vector information for the macroblock and encoded control information.

The VLC coded $N_c$ value and VLC coded *(run, level)* pairs for each block of an INTRA-coded macroblock and for each block of prediction error data associated with an INTER-coded macroblock are decoded in an identical fashion.

More specifically, when decoding the VLC coded *(run, level)* pairs for an INTRA- or INTER-coded image block, video multiplex decoder 770 first determines the number of non-zero-valued quantised transform coefficients in the block. As previously explained, information relating to the number of non-zero-valued quantised transform coefficients, $N_c$, is inserted into bit-stream 635 by encoder 600. Decoder 700 extracts this information from the received bit-stream. According to the invention, the $N_c$ value is itself VLC coded and therefore video multiplex decoder 770 performs an appropriate variable length decoding operation to recover the information relating to $N_c$. As explained above, the VLC coding table used to encode the $N_c$ value for a particular image block is selected on the basis of the $N_c$ value(s) associated with a previously encoded image block or blocks. This means that the codeword representative of the $N_c$ value for a given block can, in general, be decoded without an explicit indication of the VLC coding table from which the codeword chosen. Thus, it is only necessary for the decoder to know the VLC coding table from which the $N_c$ value for the first (few) encoded image block was selected, the coding order of the image blocks and the rule used to determine the VLC table to be used in coding subsequent $N_c$ values. The exact number of image blocks for which it is necessary to have explicit knowledge of the selected VLC coding table for $N_c$ depends on the nature of the rule used to select the VLC coding table for subsequent $N_c$ values and the block scanning order. For example, in the case that $N_c$ values from blocks to the left, top-left, top and top-right are used to select the VLC table for coding subsequent $N_c$ values and the block scanning (coding) order is from the top-left of an image, row-by-row, it is advantageous to encode $N_c$ values for blocks in the first row of the image, plus the first block on the second row according to a predetermined scheme. Then the $N_c$ values for all subsequent image blocks can be encoded according to the rule described by equation (1) above and can be decoded at the decoder without any explicit indication of the VLC coding table used.

Once the number of non-zero-valued quantised transform coefficients in the image block has been determined according to the procedure just described, video multiplex decoder 770 selects a variable length decoding table and starts to decoded the VLC encoded *(run, length)* pairs for the image block. According to invention, the VLC decoding table is selected in dependence on $N_c$. The decoding table is selected from a set of look-up tables identical to those used in the encoder. The decoding tables are stored in advance in the decoder and define the mapping between VLC codewords received in bit-stream 635 and the possible values of *(run, level)* pairs which may arise in the quantised transform coefficient data for an image block. Having selected the table in accordance with the number of non-zero-valued quantised transform coefficients, video multiplex decoder 770 uses the mappings defined in the selected look-up table to recover the *run* and *level* values. It then reconstructs the quantised transform coefficient values for the block and passes them to inverse quantiser 210. The remainder of the video decoding procedure, whereby reconstructed pixel values are formed for each image block, proceeds as described in connection with prior art video decoder 200.

It should be appreciated that the method according to the invention provides significant advantages compared with the prior art methods of VLC coding previously described. In particular, it provides a method of variable length encoding and decoding which is adaptive to the statistical characteristics of the data symbols to be encoded / decoded, while maintaining comparatively low computational complexity and high resilience to transmission errors. The adaptability of the method stems from the use of different variable length codewords and / or mappings for image blocks which have different numbers of non-zero-valued quantised transform coefficients. Computational complexity is kept low by providing the different codewords and / or mappings as look-up tables in the encoder and decoder. This also helps reduce susceptibility to data transmission errors, as the particular look-up table to be used for a given image block is signalled to the decoder by means of a value indicative of the number of non-zero-valued transform coefficients in the block.

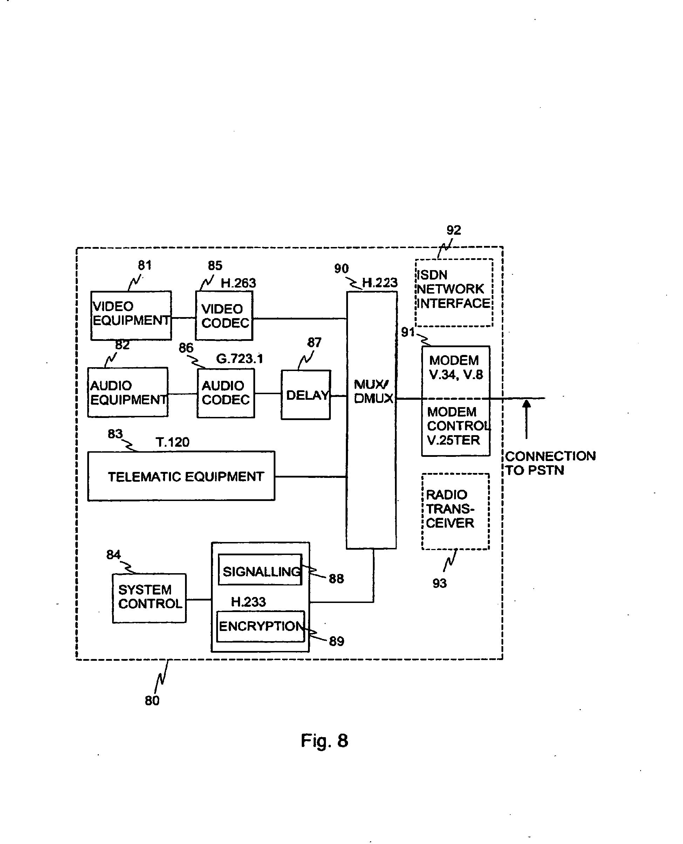

Figure 8 presents a terminal device comprising video encoding and decoding equipment which may be adapted to operate in accordance with the present invention. More precisely, the figure illustrates a multimedia terminal 80 implemented according to ITU-T recommendation H.324. The terminal can be regarded as a multimedia transceiver device. It includes elements that capture, encode and multiplex multimedia data streams for transmission via a communications network, as well as elements that receive, de-multiplex, decode and display received multimedia content. ITU-T recommendation H.324 defines the overall operation of the terminal and refers to other recommendations that govern the operation of its various constituent parts. This kind of multimedia terminal can be used in real-time applications such as conversational videotelephony, or non real-time applications such as the retrieval and / or streaming of video clips, for example from a multimedia content server in the Internet.

In the context of the present invention, it should be appreciated that the H.324 terminal shown in Figure 8 is only one of a number of alternative multimedia terminal implementations suited to application of the inventive method. It should also be noted that a number of alternatives exist relating to the location and implementation of the terminal equipment. As illustrated in Figure 8, the multimedia terminal may be located in communications equipment connected to a fixed line telephone network such as an analogue PSTN (Public Switched Telephone Network). In this case the multimedia terminal is equipped with a modem 91, compliant with ITU-T recommendations V.8, V.34 and optionally V.8bis. Alternatively, the multimedia terminal may be connected to an external modem. The modem enables conversion of the multiplexed digital data and control signals produced by the multimedia terminal into an analogue form suitable for transmission over the PSTN. It further enables the multimedia terminal to receive data and control signals in analogue form from the PSTN and to convert them into a digital data stream that can be demultiplexed and processed in an appropriate manner by the terminal.

An H.324 multimedia terminal may also be implemented in such a way that it can be connected directly to a digital fixed line network, such as an ISDN (Integrated Services Digital Network). In this case the modem 91 is replaced with an ISDN user-network interface. In Figure 8, this ISDN user-network interface is represented by alternative block 92.

H.324 multimedia terminals may also be adapted for use in mobile communication applications. If used with a wireless communication link, the modem 91 can be replaced with any appropriate wireless interface, as represented by alternative block 93 in Figure 8. For example, an H.324/M multimedia terminal can include a radio transceiver enabling connection to the current 2nd generation GSM mobile telephone network, or the proposed 3rd generation UMTS (Universal Mobile Telephone System).

It should be noted that in multimedia terminals designed for two-way communication, that is for transmission and reception of video data, it is advantageous to provide both a video encoder and video decoder implemented according to the present invention. Such an encoder and decoder pair is often implemented as a single combined functional unit, referred to as a 'codec'.

A typical H.324 multimedia terminal will now be described in further detail with reference to Figure 8.

The multimedia terminal 80 includes a variety of elements referred to as 'terminal equipment'. This includes video, audio and telematic devices, denoted generically by reference numbers 81, 82 and 83, respectively. The video equipment 81 may include, for example, a video camera for capturing video images, a monitor for displaying received video content and optional video processing equipment. The audio equipment 82 typically includes a microphone, for example for capturing spoken messages, and a loudspeaker for reproducing received audio content. The audio equipment may also include additional audio processing units. The telematic equipment 83, may include a data terminal, keyboard, electronic whiteboard or a still image transceiver, such as a fax unit.

The video equipment 81 is coupled to a video codec 85. The video codec 85 comprises a video encoder and a corresponding video decoder both implemented according to the invention. Such an encoder and a decoder will be described in the following. The video codec 85 is responsible for encoding captured video data in an appropriate form for further transmission over a communications link and decoding compressed video content received from the communications network. In the example illustrated in Figure 8, the video codec is implemented according to ITU-T recommendation H.26L, with appropriate modifications to implement the adaptive variable length coding method according to the invention in both the encoder and the decoder of the video codec.

The terminal's audio equipment is coupled to an audio codec, denoted in Figure 8 by reference number 86. Like the video codec, the audio codec comprises an encoder/decoder pair. It converts audio data captured by the terminal's audio equipment into a form suitable for transmission over the communications link and transforms encoded audio data received from the network back into a form suitable for reproduction, for example on the terminal's loudspeaker. The output of the audio codec is passed to a delay block 87. This compensates for the delays introduced by the video coding process and thus ensures synchronisation of audio and video content.

The system control block 84 of the multimedia terminal controls end-to-network signalling using an appropriate control protocol (signalling block 88) to establish a common mode of operation between a transmitting and a receiving terminal. The signalling block 88 exchanges information about the encoding and decoding capabilities of the transmitting and receiving terminals and can be used to enable the various coding modes of the video encoder. The system control block 84 also controls the use of data encryption. Information regarding the type of encryption to be used in data transmission is passed from encryption block 89 to the multiplexer/de-multiplexer (MUX/DMUX unit) 90.

During data transmission from the multimedia terminal, the MUX/DMUX unit 90 combines encoded and synchronised video and audio streams with data input from the telematic equipment 83 and possible control data, to form a single bit-stream. Information concerning the type of data encryption (if any) to be applied to the bit-stream, provided by encryption block 89, is used to select an encryption mode. Correspondingly, when a multiplexed and possibly encrypted multimedia bit-stream is being received, MUX/DMUX unit 90 is responsible for decrypting the bit-stream, dividing it into its constituent multimedia components and passing those components to the appropriate codec(s) and/or terminal equipment for decoding and reproduction.

It should be noted that the functional elements of the multimedia terminal, video encoder, decoder and video codec according to the invention can be implemented as software or dedicated hardware, or a combination of the two. The variable length coding and decoding methods according to the invention are particularly suited for implementation in the form of a computer program comprising machine-readable instructions for performing the functional steps of the invention. As such, the variable length encoder and decoder according to the invention may be implemented as software code stored on a storage medium and executed in a computer, such as a personal desktop computer.

If the multimedia terminal 80 is a mobile terminal, that is, if it is equipped with a radio transceiver 93, it will be understood by those skilled in the art that it may also comprise additional elements. In one embodiment it comprises a user interface having a display and a keyboard, which enables operation of the multimedia terminal 80 by a user, a central processing unit, such as a microprocessor, which controls the blocks responsible for different functions of the multimedia terminal, a random access memory RAM, a read only memory ROM, and a digital camera. The microprocessor's operating instructions, that is program code corresponding to the basic functions of the multimedia terminal 80, is stored in the read-only memory ROM and can be executed as required by the microprocessor, for example under control of the user. In accordance with the program code, the microprocessor uses the radio transceiver 93 to form a connection with a mobile communication network, enabling the multimedia terminal 80 to transmit information to and receive information from the mobile communication network over a radio path.

The microprocessor monitors the state of the user interface and controls the digital camera. In response to a user command, the microprocessor instructs the camera to record digital images into the RAM. Once an image is captured, or alternatively during the capturing process, the microprocessor segments the image into image segments (for example macroblocks) and uses the encoder to perform motion compensated encoding of the segments in order to generate a compressed image sequence, as explained in the foregoing description. A user may command the multimedia terminal 80 to display the captured images on its display or to send the compressed image sequence using the radio transceiver 93 to another multimedia terminal, a video telephone connected to a fixed line network (PSTN) or some other telecommunications device. In a preferred embodiment, transmission of image data is started as soon as the first segment is encoded so that the recipient can start a corresponding decoding process with a minimum delay.

**Claims**

1. A method of encoding data symbols of an image block comprising data symbols having a first value and data symbols having values other than said first value, and variable-length encoding is applied to said data symbols, **characterised in that** the method further comprises:

  - determining an average of at least the amount of data symbols having values other than said first value in a previously encoded image block and the amount of data symbols having values other than said first value in another previously encoded image block;
  - applying the variable length encoding to said data symbols of said image block;
  - determining the amount of data symbols having values other than said first value in said image block;
  - encoding an indication of said amount comprising

    - providing at least two alternative sets of variable length codewords;
    - using said average to select one set of variable length codewords of said at least two alternative sets of variable length codewords; and
    - using said amount as an index to the selected set of variable length codewords to select a variable length codeword from said selected set of variable length codewords to represent the indication; and

  - adapting the variable length encoding of said data symbols on the basis of said amount.

2. A method according to claim 1, **characterised in that** said indication of said amount is transmitted in a bit-stream to a decoding device.

3. A method according to any of claims 1 or 2, **characterised in that** it comprises representing each of said data symbols having values other than said first value by a pair of values comprising a first value indicative of the value of the data symbol and a second value indicative of a number of zero-valued data symbols preceding or following said data symbol, thereby forming a set of pairs of first and second values representing said symbols to be variable-length encoded.

4. A method according to any of claim 1 to 3, **characterised in that** it comprises performing a mapping operation in which each of said symbols to be variable length encoded is assigned to a codeword, thereby forming a set of encoded values representative of said symbols to be variable-length encoded, the codeword being selected from a set of codewords, said set of codewords having been designed to provide a reduction in an amount of information required to represent said symbols to be variable-length encoded when used in said mapping operation.

5. A method according to claim 4, **characterised in that** said mapping operation is dependent on said amount of data symbols having values other than said first value in said image block.

6. A method according to claim 5, **characterised in that** said mapping operation is performed by selecting one of a set of selectable assignment tables, wherein each table of said set of selectable assignment tables defines an assignment of symbols to be variable length encoded to codewords, and assigning each of said symbols to be variable length encoded to a codeword according to the assignment defined by said selected assignment table.

7. A method according to any of claims 1 to 6, **characterised in that** said data symbols having a first value are zero-valued data symbols and said data symbols having values other than said first value are non-zero-valued data symbols.

8. A method according to any of claims 1 to 7, **characterised in that** said data symbols are quantised transform coefficient values.

9. A method of decoding variable length codewords representing data symbols of an image block, the data symbols comprising data symbols having a first value and data symbols having values other than said first value, and said variable length codewords having been formed by applying variable-length encoding to said data symbols, **characterised in that** the method further comprises:

  - receiving a variable length codeword representing the amount of data symbols having values other than said first value;

- determining an average of at least the amount of data symbols having values other than said first value in a previously decoded image block and the amount of data symbols having values other than said first value in another previously decoded image block;
- providing at least two alternative sets of variable length codewords;
- using said average to select one set of variable length codewords of said at least two alternative sets of variable length codewords;
- using the selected set of variable length codewords to decode said received variable length codeword representing said amount to obtain said amount; and
- adapting at least one characteristic of the decoding applied to the variable length codewords representing said data symbols according to said amount.

10. A method according to claim 9, **characterised in that** said variable length encoded codeword representing said amount is received from an encoding device.

11. A method according to claim 9 or 10, **characterised in that** it comprises decoding the variable length codeword representative of said amount by performing an inverse mapping operation that defines an assignment of codewords to values.

12. A method according to claim 11, **characterised in that** said inverse mapping operation is performed by means of a mapping table that is one of a set of mapping tables and that said mapping table is selected on the basis of the amount of at least one previously encoded set of data symbols.

13. A method according to any of claims 9 to 12, **characterised in that** each of said number of symbols that were variable-length encoded is represented by a pair of values comprising a first value indicative of the value of a data symbol and a second value indicative of a number of zero-valued data symbols preceding or following said data symbol, said pairs of first and second values representing said symbols that were variable-length encoded.

14. A method according to any of claims 9 to 13, **characterised in that** it comprises performing an inverse mapping operation in which each variable length codeword is used to identify a specific one of said set of symbols that were variable-length encoded.

15. A method according to claim 14, **characterised in that** said inverse mapping operation is dependent on said indication of the amount.

16. A method according to claim 15, **characterised in that** said inverse mapping operation is performed by selecting one of a set of selectable assignment tables, wherein each table of said set of selectable assignment tables defines an assignment of symbols to be encoded to codewords, and identifying a specific one of said symbols that were variable length encoded according to the assignment defined by said selected assignment table.

17. A method according to any of claims 9 to 16, **characterised in that** said data symbols having a first value are zero-valued data symbols and said data symbols having a second value are non-zero-valued data symbols.

18. An encoder for encoding data symbols of an image block comprising data symbols having a first value and data symbols having values other than said first value, and the encoder comprises encoding means for variable-length encoding said data symbols, **characterised in that** the encoder is arranged to

- determine an average of at least the amount of data symbols having values other than said first value in a previously encoded image block and the amount of data symbols having values other than said first value in another previously encoded image block;
- determine the amount of data symbols having values other than said first value in said image block;
- encode an indication of said amount by

  - providing at least two alternative sets of variable length codewords;
  - using said average to select one set of variable length codewords of said at least two alternative sets of variable length codewords; and
  - using said amount as an index to the selected set of variable length codewords to select a variable length codeword from said selected set of variable length codewords to represent the indication; and

- adapt the variable length encoding of said data symbols on the basis of said amount.

**19.** An encoder according to claim 18, **characterised in that** it is arranged to form a bit-stream comprising said indication of the amount.

**20.** An encoder according to claim 18 or 19, **characterised in that** it is arranged to transmit said bit-stream to a decoding device.

**21.** An encoder according to any of claims 18 to 20, **characterised in that** it is arranged to select a variable length codeword to represent said amount by performing a mapping operation that defines an assignment of values to codewords.

**22.** An encoder according to claim 21, **characterised in that** it is arranged to perform said mapping operation by means of a mapping table that is one of a set of mapping tables and that it is arranged to select said mapping table on the basis of the amount of at least one previously encoded set of data symbols.

**23.** An encoder according to any of claims 18 to 22, **characterised in that** it is arranged to represent each of said second number of data symbols by a pair of values comprising a first value indicative of the value of the data symbol and a second value indicative of a number of zero-valued data symbols preceding or following said data symbol, thereby forming a set of pairs of first and second values representing said symbols to be variable-length encoded.

**24.** An encoder according to any of claims 18 to 23, **characterised in that** it is arranged to perform a mapping operation in which each of said symbols to be variable length encoded is assigned to a codeword, thereby forming a set of encoded values representative of said symbols to be variable-length encoded, the codeword being selected from a set of codewords, said set of codewords having been designed to provide a reduction in an amount of information required to represent said symbols to be variable-length encoded when used in said mapping operation.

**25.** An encoder according to claim 24, **characterised in that** said mapping operation is arranged to be dependent on said amount.

**26.** An encoder according to claim 25, **characterised in that** said mapping operation is arranged to be performed by selecting one of a set of selectable assignment tables, wherein each table of said set of selectable assignment tables defines an assignment of symbols to be variable length encoded to codewords, and assigning each of the data symbols having values other than said first value to a codeword according to the assignment defined by said selected assignment table.

**27.** An encoder according to any of claims 18 to 26, **characterised in that** said data symbols having a first value are zero-valued data symbols and said data symbols having a second value are non-zero-valued data symbols.

**28.** An encoder according to any of claims 18 to 27, provided in a video encoder.

**29.** An encoder according to any of claims 18 to 28, implemented as machine executable code stored on a computer readable storage medium.

**30.** A decoder for decoding variable length codewords representing data symbols of an image block, said data symbols comprising data symbols having a first value and data symbols having values other than said first value, and said variable length codewords having been formed by applying variable-length encoding to said data symbols , **characterised in that** the decoder is arranged to

- receive a variable length codeword representing the amount of data symbols having values other than said first value;
- determine an average of at least the amount of data symbols having values other than said first value in a previously decoded image block and the amount of data symbols having values other than said first value in another previously decoded image block;
- use said average to select one set of variable length codewords of at least two alternative sets of variable length codewords;
- use the selected set of variable length codewords to decode said received variable length codeword representing said amount to obtain said second number; and

- adapt at least one characteristic of the decoding applied to the variable length codewords representing said data symbols according to said amount.

31. A decoder according to claim 30, **characterised in that** said variable length encoded codeword representing said amount is received from an encoding device.

32. A decoder according to claim 30 or 31, **characterised in that** it is arranged to decode the variable length codeword representative of said amount by performing an inverse mapping operation that defines an assignment of codewords to values.

33. A decoder according to claim 32, **characterised in that** it is arranged to perform said inverse mapping operation by means of a mapping table that is one of a set of mapping tables and that it is arranged to select said mapping table on the basis of the number of symbols variable length encoded in at least one previously encoded set of data symbols.

34. A decoder according to any of claims 30 to 33, **characterised in that** it is arranged to decode variable length codewords representing data symbols including a pair of values, comprising a first value indicative of the value of a data symbol and a second value indicative of a number of zero-valued data symbols preceding or following said data symbol.

35. A decoder according to any of claims 30 to 34, **characterised in that** it is arranged to decode said variable length codewords by performing an inverse mapping operation in which each variable length codeword is used to identify a specific one of said set of symbols that were variable length encoded.

36. A decoder according to claim 35, **characterised in that** it is arranged to perform said inverse mapping operation dependent on said indication of the amount.

37. A decoder according to claim 36, **characterised in that** it is arranged to perform said inverse mapping operation by selecting one of a set of selectable assignment tables, wherein each table of said set of selectable assignment tables defines an assignment of symbols that were variable length encoded to codewords, and identifying a specific one of said symbols that were variable length encoded according to the assignment defined by said selected assignment table.

38. A decoder according to any of claims 30 to 37, **characterised in that** said data symbols having a first value are zero-valued data symbols and said data symbols having a second value are non-zero-valued data symbols.

39. A decoder according to any of claims 30 to 38, provided in a video decoder.

40. A decoder according to any of claims 30 to 38, implemented as machine executable code stored on a computer readable storage medium.

41. A multimedia terminal comprising an encoder according to any of claims 18 to 29.

42. A multimedia terminal comprising a decoder according to any of claims 30 to 40.

43. The multimedia terminal according to claim 41 or 42, **characterised in that** it is a mobile multimedia terminal arranged to communicate with a mobile telecommunications network by means of a radio connection.

**Patentansprüche**

1. Verfahren zum Codieren von Datensymbolen eines Bildblocks, der Datensymbole, die einen ersten Wert aufweisen, und Datensymbole, die Werte aufweisen, die nicht der erste Wert sind, umfasst, wobei eine Codierung mit variabler Länge auf die Datensymbole angewandt wird, **dadurch gekennzeichnet, dass** das Verfahren ferner Folgendes umfasst:

- Bestimmen eines Mittelwerts wenigstens der Menge von Datensymbolen, die Werte aufweisen, die nicht der erste Wert sind, in einem vorher codierten Bildblock, und der Menge von Datensymbolen, die Werte aufweisen, die nicht der erste Wert sind, in einem weiteren vorher codierten Bildblock;
- Anwenden der Codierung mit variabler Länge auf die Datensymbole des Bildblocks;
- Bestimmen der Menge von Datensymbolen, die Werte aufweisen, die nicht der erste Wert sind, in dem Bildblock;
- Codieren einer Angabe der Menge, das Folgendes umfasst:

    - Bereitstellen von wenigstens zwei alternativen Gruppen von Codewörtern variabler Länge;
    - Verwenden des Mittelwerts, um eine Gruppe von Codewörtern variabler Länge aus den wenigstens zwei alternativen Gruppen von Codewörtern variabler Länge auszuwählen; und
    - Verwenden der Menge als einen Index für die ausgewählte Gruppe von Codewörtern variabler Länge, um ein Codewort variabler Länge aus der ausgewählten Gruppe von Codewörtern variabler Länge auszuwählen, um die Angabe zu repräsentieren; und

    - Anpassen der Codierung mit variabler Länge der Datensymbole auf der Basis der Menge.

**2.** Verfahren nach Anspruch 1, **dadurch gekennzeichnet, dass** die Angabe der Menge in einem Bitstrom zu einer Decodierungsvorrichtung gesendet wird.

**3.** Verfahren nach einem der Ansprüche 1 oder 2, **dadurch gekennzeichnet, dass** es das Repräsentieren jedes der Datensymbole, die Werte aufweisen, die nicht der erste Wert sind, durch ein Wertepaar, das einen ersten Wert, der den Wert des Datensymbols angibt, und einen zweiten Wert, der eine Anzahl von Datensymbolen mit Nullwert angibt, die dem Datensymbol vorausgehen oder ihm folgen, umfasst, und dadurch das Bilden einer Gruppe von Paaren aus ersten und zweiten Werten, die die Symbole repräsentieren, die mit variabler Länge codiert werden sollen, umfasst.

**4.** Verfahren nach einem der Ansprüche 1 bis 3, **dadurch gekennzeichnet, dass** es das Ausführen einer Abbildungsoperation umfasst, in der jedes der Symbole, die mit variabler Länge codiert werden sollen, einem Codewort zugeordnet wird, und dadurch eine Gruppe von codierten Werten bildet, die repräsentativ für die Symbole sind, die mit variabler Länge codiert werden sollen, wobei das Codewort aus einer Gruppe von Codewörtern ausgewählt ist, wobei die Gruppe von Codewörtern konstruiert worden ist, um eine Reduktion einer Informationsmenge bereitzustellen, die erforderlich ist, um die Symbole zu repräsentieren, die mit variabler Länge codiert werden sollen, wenn sie in der Abbildungsoperation verwendet wird.

**5.** Verfahren nach Anspruch 4, **dadurch gekennzeichnet, dass** die Abbildungsoperation von der Menge von Datensymbolen abhängig ist, die Werte aufweisen, die nicht der erste Wert in dem Bildblock sind.

**6.** Verfahren nach Anspruch 5, **dadurch gekennzeichnet, dass** die Abbildungsoperation durch Auswählen einer Tabelle aus einer Gruppe von auswählbaren Zuweisungstabellen, wobei jede Tabelle aus der Gruppe von auswählbaren Zuordnungstabellen eine Zuordnung von Symbolen, die mit variabler Länge codiert werden sollen, zu Codewörtern definiert, und durch Zuweisen jedes der Symbole, die mit variabler Länge codiert werden sollen, zu einem Codewort gemäß der durch die ausgewählte Zuweisungstabelle definierten Zuweisung ausgeführt wird.

**7.** Verfahren nach einem der Ansprüche 1 bis 6, **dadurch gekennzeichnet, dass** die Datensymbole, die einen ersten Wert aufweisen, Nullwert-Datensymbole sind, und die Datensymbole, die Werte aufweisen, die nicht der erste Wert sind, Nichtnullwert-Datensymbole sind.

**8.** Verfahren nach einem der Ansprüche 1 bis 7, **dadurch gekennzeichnet, dass** die Datensymbole quantisierte Transformationskoeffizientenwerte sind.

**9.** Verfahren zum Decodieren von Codewörtern variabler Länge, die Datensymbole eines Bildblocks repräsentieren, wobei die Datensymbole Datensymbole, die einen ersten Wert aufweisen, und Datensymbole, die Werte aufweisen, die nicht der erste Wert sind, umfassen und die Codewörter variabler Länge durch Anwenden von Codierung mit variabler Länge auf die Datensymbole gebildet worden sind, **dadurch gekennzeichnet, dass** das Verfahren ferner Folgendes umfasst:

    - Empfangen eines Codeworts variabler Länge, das die Menge von Datensymbolen repräsentiert, die Werte aufweisen, die nicht der erste Wert sind;
    - Bestimmen eines Mittelwerts wenigstens der Menge von Datensymbolen, die Werte aufweisen, die nicht der erste Wert sind, in einem vorher decodierten Bildblock, und der Menge von Datensymbolen in einem Bildblock, die Werte aufweisen, die nicht der erste Wert sind, in einem weiteren vorher decodierten Bildblock;
- Bereitstellen von wenigstens zwei alternativen Gruppen von Codewörtern variabler Länge;
- Verwenden des Mittelwerts, um eine Gruppe von Codewörtern variabler Länge aus den wenigstens zwei alternativen Gruppen von Codewörtern variabler Länge auszuwählen;
- Verwenden der ausgewählten Gruppe von Codewörtern variabler Länge, um das empfangene Codewort variabler Länge, das die Menge repräsentiert, zu decodieren, um die Menge zu erhalten; und
- Anpassen wenigstens einer Eigenschaft der Decodierung, die auf die Codewörter variabler Länge angewandt wird, die die Datensymbole repräsentieren, gemäß der Menge.

10. Verfahren nach Anspruch 9, **dadurch gekennzeichnet, dass** das mit variabler Länge codierte Codewort, das die Menge repräsentiert, von einer Codierungsvorrichtung empfangen wird.

11. Verfahren nach Anspruch 9 oder 10, **dadurch gekennzeichnet, dass** es das Decodieren des Codeworts variabler Länge umfasst, das die Menge repräsentiert, durch Ausführen einer inversen Abbildungsoperation, die eine Zuweisung von Codewörtern zu Werten definiert.

12. Verfahren nach Anspruch 11, **dadurch gekennzeichnet, dass** die inverse Abbildungsoperation mittels einer Abbildungstabelle, die eine aus einer Gruppe von Abbildungstabellen ist, ausgeführt wird, und dass die Abbildungstabelle auf der Basis der Menge der wenigstens einen vorher codierten Gruppe von Datensymbolen ausgewählt wird.

13. Verfahren nach einem der Ansprüche 9 bis 12, **dadurch gekennzeichnet, dass** jedes aus der Anzahl von Symbolen, die mit variabler Länge codiert wurden, durch ein Wertepaar repräsentiert wird, das einen ersten Wert, der den Wert eines Datensymbols angibt, und einen zweiten Wert, der eine Anzahl von Nullwert-Datensymbolen angibt, die dem Datensymbol vorausgehen oder ihm folgen, umfasst, wobei die Paare aus ersten und zweiten Werten, die die Symbole repräsentieren, mit variabler Länge codiert wurden.

14. Verfahren nach einem der Ansprüche 9 bis 13, **dadurch gekennzeichnet, dass** es das Ausführen einer inversen Abbildungsoperation, in der jedes Codewort variabler Länge verwendet wird, um ein spezifisches Symbol aus der Gruppe von Symbolen zu identifizieren, die mit variabler Länge codiert wurden, umfasst.

15. Verfahren nach Anspruch 14, **dadurch gekennzeichnet, dass** die inverse Abbildungsoperation von der Angabe der Menge abhängt.

16. Verfahren nach Anspruch 15, **dadurch gekennzeichnet, dass** die inverse Abbildungsoperation durch Auswählen einer Tabelle aus einer Gruppe von auswählbaren Zuweisungstabellen, wobei jede Tabelle aus der Gruppe von auswählbaren Zuordnungstabellen eine Zuordnung von Symbolen, die mit variabler Länge codiert werden sollen, zu Codewörtern definiert, und durch Identifizieren eines spezifischen Symbols aus den Symbolen, die mit variabler Länge codiert wurden, gemäß der Zuweisung, die durch die ausgewählte Zuweisungstabelle definiert ist, ausgeführt wird.

17. Verfahren nach einem der Ansprüche 9 bis 16, **dadurch gekennzeichnet, dass** die Datensymbolen, die einen ersten Wert aufweisen, Nullwert-Datensymbole sind, und die Datensymbolen, die einen zweiten Wert aufweisen, Nichtnullwert-Datensymbole sind.

18. Codierer zum Codieren von Datensymbolen eines Bildblocks, der Datensymbole umfasst, die einen ersten Wert aufweisen, und Datensymbole, die Werte aufweisen, die nicht der erste Wert sind, und wobei der Codierer Codierungsmittel zur Codierung der Datensymbole mit variabler Länge umfasst, **dadurch gekennzeichnet, dass** der Codierer ausgelegt ist:

- einen Mittelwert wenigstens der Menge von Datensymbolen, die Werte aufweisen, die nicht der erste Wert sind, in einem vorher codierten Bildblock, und der Menge von Datensymbolen in einem Bildblock, die Werte aufweisen, die nicht der erste Wert sind, in einem weiteren vorher codierten Bildblock zu bestimmen;
- die Menge von Datensymbolen, die Werte aufweisen, die nicht der erste Wert sind, in dem Bildblock zu bestimmen;
- eine Angabe der Menge zu codieren durch

- Bereitstellen von wenigstens zwei alternativen Gruppen von Codewörtern variabler Länge;
- Verwenden des Mittelwerts, um eine Gruppe von Codewörtern variabler Länge aus den wenigstens zwei alternativen Gruppen von Codewörtern variabler Länge auszuwählen; und

- Verwenden der Menge als einen Index für die ausgewählte Gruppe von Codewörtern variabler Länge, um ein Codewort variabler Länge aus der ausgewählten Gruppe von Codewörtern variabler Länge auszuwählen, um die Angabe zu repräsentieren; und

- die Codierung mit variabler Länge auf die Datensymbole auf der Basis der Menge anzupassen.

19. Codierer nach Anspruch 18, **dadurch gekennzeichnet, dass** er ausgelegt ist, einen Bitstrom zu bilden, der die Angabe der Menge umfasst.

20. Codierer nach Anspruch 19 oder 19, **dadurch gekennzeichnet, dass** er ausgelegt ist, den Bitstrom zu einer Decodierungsvorrichtung zu senden.

21. Codierer nach einem der Ansprüche 18 bis 20, **dadurch gekennzeichnet, dass** er ausgelegt ist, ein Codewort variabler Länge auszuwählen, um die Menge zu repräsentieren, durch Ausführen einer Abbildungsoperation, die eine Zuweisung von Werten zu Codewörtern definiert.

22. Codierer nach Anspruch 21, **dadurch gekennzeichnet, dass** er ausgelegt ist, die Abbildungsoperation mittels einer Abbildungstabelle auszuführen, die eine aus einer Gruppe von Abbildungstabellen ist, und dass er ausgelegt ist, die Abbildungstabelle auf der Basis der Menge wenigstens einer vorher codierten Gruppe von Datensymbolen auszuwählen.

23. Codierer nach einem der Ansprüche 18 bis 22, **dadurch gekennzeichnet, dass** er ausgelegt ist, jedes der zweiten Anzahl von Datensymbolen durch ein Wertepaar, das einen ersten Wert, der den Wert des Datensymbols angibt, und einen zweiten Wert, der eine Anzahl von Datensymbolen mit Nullwert angibt, die dem Datensymbol vorausgehen oder ihm folgen, umfasst, zu repräsentieren und dadurch eine Gruppe von Paaren aus ersten und zweiten Werten zu bilden, die die Symbole repräsentieren, die mit variabler Länge codiert werden sollen.

24. Codierer nach einem der Ansprüche 18 bis 23, **dadurch gekennzeichnet, dass** er ausgelegt ist, eine Abbildungsoperation auszuführen, in der jedes der Symbole, die mit variabler Länge codiert werden sollen, einem Codewort zugeordnet wird, und dadurch eine Gruppe von codierten Werten bildet, die repräsentativ für die Symbole sind, die mit variabler Länge codiert werden sollen, wobei das Codewort aus einer Gruppe von Codewörtern ausgewählt ist, wobei die Gruppe von Codewörtern konstruiert worden ist, um eine Reduktion einer Informationsmenge bereitzustellen, die erforderlich ist, um die Symbole zu repräsentieren, die mit variabler Länge codiert werden sollen, wenn sie in der Abbildungsoperation verwendet werden.

25. Codierer nach Anspruch 24, **dadurch gekennzeichnet, dass** die Abbildungsoperation ausgelegt ist, von der Menge abhängig zu sein.

26. Codierer nach Anspruch 25, **dadurch gekennzeichnet, dass** die Abbildungsoperation ausgelegt ist, durch Auswählen einer aus einer Gruppe von auswählbaren Zuweisungstabellen, wobei jede Tabelle aus der Gruppe von auswählbaren Zuordnungstabellen eine Zuordnung von Symbolen, die mit variabler Länge codiert werden sollen, zu Codewörtern definiert, und durch Zuweisen jedes der Datensymbole, die Werte aufweisen, die nicht der erste Wert sind, zu einem Codewort gemäß der Zuweisung, die durch die ausgewählte Zuweisungstabelle definiert ist, ausgeführt zu werden.

27. Codierer nach einem der Ansprüche 18 bis 26, **dadurch gekennzeichnet, dass** die Datensymbolen, die einen ersten Wert aufweisen, Nullwert-Datensymbole sind, und die Datensymbolen, die einen zweiten Wert aufweisen, Nichtnullwert-Datensymbole sind.

28. Codierer nach einem der Ansprüche 18 bis 27, der in einem Videocodierer bereitgestellt ist.

29. Codierer nach einem der Ansprüche 18 bis 28, der als maschinenausführbarer Code, der in einem computerlesbaren Speichermedium gespeichert ist, implementiert ist.

30. Decodierer zum Decodieren von Codewörtern variabler Länge, die Datensymbole eines Bildblocks repräsentieren, wobei die Datensymbole Datensymbole, die einen ersten Wert aufweisen, und Datensymbole, die Werte aufweisen, die nicht der erste Wert sind, umfassen und die Codewörter variabler Länge durch Anwenden von Codierung mit variabler Länge auf die Datensymbole gebildet worden sind, **dadurch gekennzeichnet, dass** der Decodierer ausgelegt ist:

- ein Codewort variabler Länge, das die Menge von Datensymbolen repräsentiert, die Werte aufweisen, die nicht der erste Wert sind, zu empfangen;
- einen Mittelwert wenigstens der Menge von Datensymbolen, die Werte aufweisen, die nicht der erste Wert sind, in einem vorher decodierten Bildblock, und der Menge von Datensymbolen, die Werte aufweisen, die nicht der erste Wert sind, in einem weiteren vorher decodierten Bildblock zu bestimmen;
- den Mittelwert zu verwenden, um eine Gruppe von Codewörtern variabler Länge aus wenigstens zwei alternativen Gruppen von Codewörtern variabler Länge auszuwählen;
- die ausgewählten Gruppe von Codewörtern variabler Länge zu verwenden, um das empfangene Codewort variabler Länge, das die Menge repräsentiert, zu decodieren, um die zweite Anzahl zu erhalten; und
- wenigstens eine Eigenschaft der Decodierung, die auf die Codewörter variabler Länge angewandt werden, die die Datensymbole repräsentieren, gemäß der Menge anzupassen.

31. Decodierer nach Anspruch 30, **dadurch gekennzeichnet, dass** das mit variabler Länge codierte Codewort, das die Menge repräsentiert, von einer Codierungsvorrichtung empfangen wird.

32. Decodierer nach Anspruch 30 oder 31, **dadurch gekennzeichnet, dass** er ausgelegt ist, das Codewort variabler Länge, das die Menge repräsentiert, durch Ausführen einer inversen Abbildungsoperation, die eine Zuweisung von Codewörtern zu Werten definiert, zu decodieren.

33. Decodierer nach Anspruch 32, **dadurch gekennzeichnet, dass** er ausgelegt ist, die inverse Abbildungsoperation mittels einer Abbildungstabelle, die einer aus einer Gruppe von Abbildungstabellen ist, auszuführen, und dass er ausgelegt ist, die Abbildungstabelle auf der Basis der Anzahl von Symbolen, die mit variabler Länge codiert sind, in wenigstens einer vorher codierten Gruppe von Datensymbolen auszuwählen.

34. Decodierer nach einem der Ansprüche 30 bis 33, **dadurch gekennzeichnet, dass** er ausgelegt ist, Codewörter variabler Länge zu decodieren, die Datensymbole repräsentieren, die ein Wertepaar enthalten, das einen ersten Werte, der einen Wert des Datensymbols angibt, und einen zweiten Wert, der eine Anzahl von Nullwert-Datensymbolen angibt, die dem Datensymbol vorausgehen oder ihm nachfolgen, umfasst.

35. Decodierer nach einem der Ansprüche 30 bis 34, **dadurch gekennzeichnet, dass** er ausgelegt ist, die Codewörter variabler Länge zu decodieren durch Ausführen einer inversen Abbildungsoperation, in der jedes Codewort variabler Länge verwendet wird, um ein spezifisches Symbol der Gruppe von Symbolen, die mit variabler Länge codiert wurden, zu identifizieren.

36. Decodierer nach Anspruch 35, **dadurch gekennzeichnet, dass** er ausgelegt ist, die inverse Abbildungsoperation abhängig von der Angabe der Menge auszuführen.

37. Decodierer nach Anspruch 36, **dadurch gekennzeichnet, dass** er ausgelegt ist, die inverse Abbildungsoperation durch Auswählen einer Tabelle aus einer Gruppe von auswählbaren Zuweisungstabellen, wobei jede Tabelle aus der Gruppe von auswählbaren Zuordnungstabellen eine Zuordnung von Symbolen, die mit variabler Länge codiert werden sollen, zu Codewörtern definiert, und durch Identifizieren eines spezifischen Symbols aus den Symbolen, die mit variabler Länge codiert wurden, gemäß der Zuweisung, die durch die ausgewählte Zuweisungstabelle definiert ist, auszuführen.

38. Decodierer nach einem der Ansprüche 30 bis 37, **dadurch gekennzeichnet, dass** die Datensymbolen, die einen ersten Wert aufweisen, Nullwert-Datensymbole sind, und die Datensymbolen, die einen zweiten Wert aufweisen, Nichtnullwert-Datensymbole sind.

39. Decodierer nach einem der Ansprüche 30 bis 38, der in einem Videodecodierer bereitgestellt ist.

40. Decodierer nach einem der Ansprüche 30 bis 38, der als maschinenausführbarer Code, der in einem computerlesbaren Speichermedium gespeichert ist, implementiert ist.

41. Multimediaendgerät, das einen Codierer nach einem der Ansprüche 18 bis 29 umfasst.

**42.** Multimediaendgerät, das einen Decodierer nach einem der Ansprüche 30 bis 40 umfasst.

**43.** Multimediaendgerät nach Anspruch 41 oder 42, **dadurch gekennzeichnet, dass** es ein mobiles Multimediaendgerät ist, das ausgelegt ist, mit einem Mobiltelekommunikationsnetz mittels einer Funkverbindung zu kommunizieren.

**Revendications**

**1.** Procédé de codage de symboles de données d'un bloc d'image comprenant des symboles de données ayant une première valeur et des symboles de données ayant des valeurs autres que ladite première valeur, et un code à longueur variable est appliqué auxdits symboles de données, **caractérisé en ce que** le procédé comprend en outré :

- la détermination d'une moyenne d'au moins la quantité de symboles de données ayant des valeurs autres que ladite première valeur dans un bloc d'image codé antérieurement et la quantité de symboles de données ayant des valeurs autres que ladite première valeur dans un autre bloc d'image codé antérieurement ;
- l'application du codage à longueur variable auxdits symboles de données dudit bloc d'image ;
- la détermination de la quantité de symboles de données ayant des valeurs autres que ladite première valeur dans ledit bloc d'image ;
- le codage d'une indication de ladite quantité comprenant

- la fourniture d'au moins deux ensembles possibles de mots de code à longueur variable ;
- l'utilisation de ladite moyenne pour sélectionner un ensemble de mots de code à longueur variable desdits au moins deux ensembles de mots de code à longueur variable ; et
- l'utilisation de ladite quantité comme indice de l'ensemble sélectionné de mots de code à longueur variable pour sélectionner un mot de code à longueur variable parmi ledit ensemble sélectionné de mots de code à longueur variable pour représenter l'indication ; et

- l'adaptation du codage à longueur variable desdits symboles de données en fonction de ladite quantité.

**2.** Procédé selon la revendication 1, **caractérisé en ce que** ladite indication de ladite quantité est transmis dans un flux binaire à un dispositif de décodage.

**3.** Procédé selon l'une quelconque des revendications 1 ou 2, **caractérisé en ce qu'**il comprend la représentation de chacun desdits symboles de données ayant des valeurs autres que ladite première valeur par une paire de valeurs comprenant une première valeur indicative de la valeur du symbole de données et une seconde valeur indicative d'un nombre de symboles de données de valeur nulle précédant ou suivant ledit symbole de données, formant ainsi un ensemble de paires de première et seconde valeurs représentant lesdits symboles à coder par codage à longueur variable.

**4.** Procédé selon l'une quelconque des revendications 1 à 3, **caractérisé en ce qu'**il comprend l'exécution d'une opération de mise en correspondance dans laquelle chacun desdits symboles à coder par codage à longueur variable est attribué à un mot de code, formant ainsi un ensemble de valeurs codées représentatives desdits symboles à coder par codage à longueur variable, le mot de code étant sélectionné parmi un ensemble de mots de code, ledit ensemble de mots de code ayant été conçu pour réduire la quantité d'informations requises pour représenter lesdits symboles à coder par codage à longueur variable quand il est utilisé dans ladite opération de mise en correspondance.

**5.** Procédé selon la revendication 4, **caractérisé en ce que** ladite opération de mise en correspondance dépend de ladite quantité de symboles de données ayant des valeurs autres que ladite première valeur dans ledit bloc d'image.

**6.** Procédé selon la revendication 5, **caractérisé en ce que** ladite opération de mise en correspondance est exécutée en sélectionnant l'une d'un ensemble de tables d'attribution sélectionnables, chaque table dudit ensemble de tables d'attribution sélectionnables définissant une attribution de symboles à coder par codage à longueur variable à des mots de code, et l'attribution de chacun desdits symboles à coder par codage à longueur variable à un mot de code en fonction de l'attribution définie par ladite table d'attribution sélectionnée.

**7.** Procédé selon l'une quelconque des revendications 1 à 6, **caractérisé en ce que** lesdits symboles de données ayant une première valeur sont des symboles de données de valeur nulle et lesdits symboles de données ayant des valeurs autres que ladite première valeur sont des symboles de données de valeur non nulle.

8. Procédé selon l'une quelconque des revendications 1 à 7, **caractérisé en ce que** lesdits symboles de données sont des valeurs de coefficients de transformée quantifiés.

9. Procédé de décodage de mots de code à longueur variable représentant des symboles de données d'un bloc d'image, les symboles de données comprenant des symboles de données ayant une première valeur et des symboles de données ayant des valeurs autres que ladite première valeur, et lesdits mots de code à longueur variable ayant été formés en appliquant un codage à longueur variable auxdits symboles de données, **caractérisé en ce que** le procédé comprend en outré :

- la réception d'un mot de code à longueur variable représentant la quantité de symboles de données ayant des valeurs autres que ladite première valeur ;
- la détermination d'une moyenne d'au moins la quantité de symboles de données ayant des valeurs autres que ladite première valeur dans un bloc d'image décodé antérieurement et la quantité de symboles de données ayant des valeurs autres que ladite première valeur dans un autre bloc d'image décodé antérieurement ;
- la fourniture d'au moins deux ensembles possibles de mots de code à longueur variable ;
- l'utilisation de ladite moyenne pour sélectionner un ensemble de mots de code à longueur variable desdits au moins deux autres ensembles de mots de code à longueur variable ;
- l'utilisation de l'ensemble sélectionné de mots de code à longueur variable pour décoder ledit mot de code à longueur variable reçu représentant ladite quantité pour obtenir ladite quantité ; et
- l'adaptation d'au moins une caractéristique du décodage appliqué aux mots de code à longueur variable représentant lesdits symboles de données en fonction de ladite quantité.

10. Procédé selon la revendication 9, **caractérisé en ce que** ledit mot de code codé par codage à longueur variable représentant ladite quantité est reçu depuis un dispositif de codage.

11. Procédé selon la revendication 9 ou 10, **caractérisé en ce qu'**il comprend le décodage du mot de code à longueur variable représentatif de ladite quantité en exécutant une opération de mise en correspondance inverse qui définit une attribution de mots de code à des valeurs.

12. Procédé selon la revendication 11, **caractérisé en ce que** ladite opération de mise en correspondance inverse est exécutée au moyen d'une table de mise en correspondance qui est l'une d'un ensemble de tables de mise en correspondance et **en ce que** ladite table de mise en correspondance est sélectionnée en fonction de la quantité d'au moins un ensemble codé antérieurement de symboles de données.

13. Procédé selon l'une quelconque des revendications 9 à 12, **caractérisé en ce que** chacun dudit nombre de symboles qui ont été codés par codage à longueur variable est représenté par une paire de valeurs comprenant une première valeur indicative de la valeur d'un symbole de données et une seconde valeur indicative d'un nombre de symboles de données de valeur nulle précédant ou suivant ledit symbole de données, lesdites paires de première et seconde valeurs représentant lesdits symboles qui ont été codés par codage à longueur variable.

14. Procédé selon l'une quelconque des revendications 9 à 13, **caractérisé en ce qu'**il comprend l'exécution d'une opération de mise en correspondance inverse dans laquelle chaque mot de code à longueur variable est utilisé pour identifier un symbole spécifique dudit ensemble de symboles qui ont été codés par codage à longueur variable.

15. Procédé selon la revendication 14, **caractérisé en ce que** ladite opération de mise en correspondance inverse dépend de ladite indication de la quantité.

16. Procédé selon la revendication 15, **caractérisé en ce que** ladite opération de mise en correspondance inverse est exécutée en sélectionnant l'une d'un ensemble de tables d'attribution sélectionnables, chaque table dudit ensemble de tables d'attribution sélectionnables définissant une attribution de symboles à coder par codage à longueur variable à des mots de code, et identifiant un symbole spécifique desdits symboles qui ont été codés par codage à longueur variable en fonction de l'attribution définie par ladite table d'attribution sélectionnée.

17. Procédé selon l'une quelconque des revendications 9 à 16, **caractérisé en ce que** lesdits symboles de données ayant une première valeur sont constitués par des symboles de données de valeur nulle et lesdits symboles de données ayant une seconde valeur sont constitués par des symboles de données de valeur non nulle.

18. Codeur pour coder des symboles de données d'un bloc d'image comprenant des symboles de données ayant une première valeur et des symboles de données ayant des valeurs autres que ladite première valeur, et le codeur comprend un moyen de codage pour un codage à longueur variable desdits symboles de données, **caractérisé en ce que** le codeur est agencé pour :

- déterminer une moyenne d'au moins la quantité de symboles de données ayant des valeurs autres que ladite première valeur dans un bloc d'image codé antérieurement et la quantité de symboles de données ayant des valeurs autres que ladite première valeur dans un autre bloc d'image codé antérieurement ;
- déterminer la quantité de symboles de données ayant des valeurs autres que ladite première valeur dans ledit bloc d'image ;
- coder une indication de ladite quantité en

- fournissant au moins deux ensembles possibles de mots de code à longueur variable ;
- utilisant ladite moyenne pour sélectionner un ensemble de mots de code à longueur variable desdits au moins deux ensembles de mots de code à longueur variable ; et
- utilisant ladite quantité comme indice de l'ensemble sélectionné de mots de code à longueur variable pour sélectionner un mot de code à longueur variable parmi ledit ensemble sélectionné de mots de code à longueur variable pour représenter l'indication ; et

- adapter le codage à longueur variable desdits symboles de données en fonction de ladite quantité.

19. Codeur selon la revendication 20, **caractérisé en ce qu'**il est agencé pour former un flux binaire comprenant ladite indication de la quantité.

20. Codeur selon la revendication 18 ou 19, **caractérisé en ce qu'**il est agencé pour transmettre ledit flux binaire à un dispositif de décodage.

21. Codeur selon l'une quelconque des revendications 18 à 20, **caractérisé en ce qu'**il est agencé pour sélectionner un mot de code à longueur variable pour représenter ladite quantité en exécutant une opération de mise en correspondance qui définit une attribution de valeurs à des mots de code.

22. Codeur selon la revendication 21, **caractérisé en ce qu'**il est agencé pour exécuter ladite opération de mise en correspondance au moyen d'une table de mise en correspondance qui est l'une d'un ensemble de tables de mise en correspondance et qui est agencé pour sélectionner ladite table de mise en correspondance en fonction de la quantité d'au moins un ensemble codé antérieurement de symboles de données.

23. Codeur selon l'une quelconque des revendications 18 à 22, **caractérisé en ce qu'**il est agencé pour représenter chacun dudit second nombre de symboles de données par une paire de valeurs comprenant une première valeur indicative de la valeur du symbole de données et une seconde valeur indicative d'un nombre de symboles de données de valeur nulle précédant ou suivant ledit symbole de données, formant ainsi un ensemble de paires de première et seconde valeurs représentant lesdits symboles à coder par codage à longueur variable.

24. Codeur selon l'une quelconque des revendications 18 à 23, **caractérisé en ce qu'**il est agencé pour exécuter une opération de mise en correspondance dans laquelle chacun desdits symboles à coder par codage à longueur variable est attribué à un mot de code, formant ainsi un ensemble de valeurs codées représentatives desdits symboles à coder par codage à longueur variable, le mot de code étant sélectionné parmi un ensemble de mots de code, ledit ensemble de mots de code ayant été conçu pour réduire la quantité d'informations requises pour représenter lesdits symboles à coder par codage à longueur variable quand il est utilisé dans ladite opération de mise en correspondance.

25. Codeur selon la revendication 24, **caractérisé en ce que** ladite opération de mise en correspondance dépend de ladite quantité.

26. Codeur selon la revendication 25, **caractérisé en ce que** ladite opération de mise en correspondance est agencée pour être exécutée en sélectionnant l'une d'un ensemble de tables d'attribution sélectionnables, chaque table dudit ensemble de tables d'attribution sélectionnables définissant une attribution de symboles à coder par codage à longueur variable à des mots de code, et attribuant chacun des symboles de données ayant des valeurs autres que la première valeur à un mot de code en fonction de l'attribution définie par ladite table d'attribution sélectionnée.

**27.** Codeur selon l'une quelconque des revendications 18 à 26, **caractérisé en ce que** lesdits symboles de données ayant une première valeur sont constitués par des symboles de données de valeur nulle et lesdits symboles de données ayant une seconde valeur sont constitués par des symboles de données de valeur non nulle.

**28.** Codeur selon l'une quelconque des revendications 18 à 27, fourni dans un codeur vidéo.

**29.** Codeur selon l'une quelconque des revendications 18 à 28, mis en oeuvre comme un code exécutable par machine mémorisé sur un support de mémorisation lisible par ordinateur.

**30.** Décodeur pour décoder des mots de code à longueur variable représentant des symboles de données d'un bloc d'image, lesdits symboles de données comprenant des symboles de données ayant une première valeur et des symboles de données ayant des valeurs autres que ladite première valeur, et lesdits mots de code à longueur variable ayant été formés en appliquant un codage à longueur variable auxdits symboles de données, **caractérisé en ce que** le décodeur est agencé pour :

- recevoir un mot de code à longueur variable représentant la quantité de symboles de données ayant des valeurs autres que ladite première valeur ;
- déterminer une moyenne d'au moins la quantité de symboles de données ayant des valeurs autres que ladite première valeur dans un bloc d'image décodé antérieurement et la quantité de symboles de données ayant des valeurs autres que ladite première valeur dans un autre bloc d'image décodé antérieurement ;
- utiliser ladite moyenne pour sélectionner un ensemble de mots de code à longueur variable desdits au moins deux ensembles possibles de mots de code à longueur variable ;
- utiliser l'ensemble sélectionné de mots de code à longueur variable pour décoder ledit mot de code à longueur variable reçu représentant ladite quantité pour obtenir ladite quantité ; et
- adapter au moins une caractéristique du décodage appliqué aux mots de code à longueur variable représentant lesdits symboles de données en fonction de ladite quantité.

**31.** Décodeur selon la revendication 30, **caractérisé en ce que** ledit mot de code codé par codage à longueur variable représentant ladite quantité est reçu depuis un dispositif de codage.

**32.** Décodeur selon la revendication 30 ou 31, **caractérisé en ce qu'**il est agencé pour décoder le mot de code à longueur variable représentatif ladite quantité en exécutant une opération de mise en correspondance inverse qui définit une attribution de mots de code à des valeurs.

**33.** Décodeur selon la revendication 32, **caractérisé en ce qu'**il est agencé pour exécuter ladite opération de mise en correspondance inverse au moyen d'une table de mise en correspondance qui est l'une d'un ensemble de tables de mise en correspondance et **en ce qu'**il est agencé pour sélectionner ladite table de mise en correspondance en fonction du nombre de symboles codées par codage à longueur variable dans au moins un ensemble codé antérieurement de symbole de données.

**34.** Décodeur selon l'une quelconque des revendications 30 à 33, **caractérisé en ce qu'**il est agencé pour décoder des mots de code à longueur variable représentant des symboles de données comportant une paire de valeurs, comprenant une première valeur indicative de la valeur d'un symbole de données et une seconde valeur indicative d'un nombre de symboles de données de valeur nulle précédant ou suivant ledit symbole de données.

**35.** Décodeur selon l'une quelconque des revendications 30 à 34, **caractérisé en ce qu'**il est agencé pour décoder lesdits mots de code à longueur variable en exécutant une opération de mise en correspondance inverse dans laquelle chaque mot de code à longueur variable est utilisé pour identifier un symbole spécifique dudit ensemble de symboles qui ont été codés par codage à longueur variable.

**36.** Décodeur selon la revendication 35, **caractérisé en ce qu'**il est agencé pour exécuter ladite opération de mise en correspondance inverse en fonction de ladite indication de ladite quantité.

**37.** Décodeur selon la revendication 36, **caractérisé en ce qu'**il est agencé pour exécuter ladite opération de mise en correspondance inverse en sélectionnant l'une d'un ensemble de tables d'attribution sélectionnables, chaque table dudit ensemble de tables d'attribution sélectionnables définissant une attribution de symboles à coder par codage à longueur variable à des mots de code, et identifiant un symbole spécifique desdits symboles qui ont été codés par codage à longueur variable en fonction de l'attribution définie par ladite table d'attribution sélectionnée.

**38.** Décodeur selon l'une quelconque des revendications 30 à 37, **caractérisé en ce que** lesdits symboles de données ayant une première valeur sont constitués par des symboles de données de valeur nulle et lesdits symboles de données ayant une seconde valeur sont constitués par des symboles de données de valeur non nulle.

**39.** Décodeur selon l'une quelconque des revendications 30 à 38, fourni dans un décodeur vidéo.

**40.** Décodeur selon l'une quelconque des revendications 30 à 38, mis en oeuvre comme un code exécutable par machine mémorisé sur un support de mémorisation lisible par ordinateur.

**41.** Terminal multimédia comprenant un codeur selon l'une quelconque des revendications 18 à 29.

**42.** Terminal multimédia comprenant un décodeur selon l'une quelconque des revendications 30 à 40.

**43.** Terminal multimédia selon la revendication 41 ou 42, **caractérisé en ce qu'**il s'agit d'un terminal multimédia mobile agencé pour communiquer avec un réseau de télécommunications mobile au moyen d'une connexion radio.

Fig. 1

Fig. 2

Figure 3

Figure 4

| Top-Left<br>Nc_TL | Top<br>Nc_T | Top-Right<br>Nc_TR |
|---|---|---|
| Left<br>Nc_L | Current<br>block | |

Fig. 5

Fig. 6

Fig. 7

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

• US 5640420 A

### Non-patent literature cited in the description

• **G. BJONTEGAARD.** H.26L Test Model Long Term Number 8 (TML-8) draft 0. *VCEG-N10,* June 2001
• Working Draft Number 2, Doc. JVT-B118, Joint Video Team (JVT) of ISO/IEC MPEG and ITU-T VCEG Pattaya. *2nd JVT Meeting, Geneva, CH,* 29 January 2002

• **GISLE BJONTEGAARD.** Use of Adaptive Switching Between Two VLCs for INTRA Luma Coefficients. *Q.15/SG16,* August 2000